# FASCICULE DE BREVET EUROPEEN

(11) **EP 3 996 275 B1**
(45) Date de publication et mention de la délivrance du brevet: **25.03.2026**
(21) Numéro de dépôt: 21202238.8
(22) Date de dépôt: 12.10.2021
(51) Int. Cl.: H03H 9/02, H03H 9/64

(54) **DISPOSITIF ÉLECTROMÉCANIQUE À FRÉQUENCE DE RÉSONANCE AJUSTABLE**
ELEKTROMECHANISCHE VORRICHTUNG MIT EINSTELLBARER RESONANZFREQUENZ
ELECTROMECHANICAL DEVICE WITH ADJUSTABLE RESONANCE FREQUENCY

(30) Priorité: 19.10.2020 FR 2010704
(43) Date de publication de la demande: 11.05.2022
(73) Titulaire: Commissariat à l'Energie Atomique et aux Energies Alternatives, 75015 Paris (FR)
(72) Inventeur: REINHARDT, Alexandre, 38054 GRENOBLE CEDEX 09 (FR); REIG, Bruno, 38054 GRENOBLE CEDEX 09 (FR); SAUVAGE, Axel, 38054 GRENOBLE CEDEX 09 (FR)
(74) Mandataire: Cabinet Camus Lebkiri

(56) Documents cités:
- JP-A- 2011 259 516
- JP-A- 2015 144 418
- JP-U- S6 392 421
- US-A- 5 010 269
- US-A- 6 160 339
- ZOU JIE ET AL: "Electrode design of AlN Lamb wave resonators", 2016 IEEE INTERNATIONAL FREQUENCY CONTROL SYMPOSIUM (IFCS), IEEE, 9 May 2016 (2016-05-09), pages 1 - 5, XP032958615, [retrieved on 20160908]

## Description

### DOMAINE TECHNIQUE

Le domaine technique est celui des dispositifs électromécaniques exploitant la propagation d'ondes élastiques en vue de réaliser des fonctions de résonateurs électriques, ces résonateurs pouvant à leur tour servir à la réalisation de fonctions plus complexes telles que des filtres, des références de fréquence ou autres. Ces dispositifs présentent typiquement des fréquences de résonance pouvant aller de quelques centaines de kHz à quelques GHz.

### ARRIERE-PLAN TECHNOLOGIQUE

Dans ce domaine, on connait des dispositifs basés sur des résonateurs à ondes élastiques de surface (ou « SAW », pour Surface Acoustic Wave, en anglais). De tels dispositifs comprennent généralement un substrat piézoélectrique massif, relativement épais. Les ondes élastiques en question, du type ondes de Rayleigh, ondes de surface transverse (« STW », pour Surface Transverse Wave en anglais), ou ondes de volume rampantes (« SSBW », pour Surface Skimming Bulk Wave en anglais), se propagent à la surface du substrat, parallèlement à cette surface.

Deux réflecteurs, réfléchissants pour ces ondes de surface et situés en vis-à-vis l'un de l'autre, sont alors réalisés sur la surface du substrat pour former un résonateur à ondes élastiques de surface. Ces réflecteurs peuvent être réalisés en déposant des électrodes métalliques sur la surface du substrat, ces électrodes comprenant chacune plusieurs bandes métalliques disposées périodiquement pour former une sorte de miroir de Bragg.

Pour permettre d'interagir électriquement avec ce résonateur, un transducteur comprenant deux électrodes en forme de peignes interdigités est généralement réalisé sur la surface du substrat, entre les deux réflecteurs. Ces deux électrodes sont reliées respectivement à deux bornes de connexion. Une résonance électrique, associée à une résonance d'ondes élastiques dans le résonateur, est alors obtenue entre ces deux bornes. Cette résonance électrique peut servir de base à la réalisation de filtres ou d'oscillateurs, par exemple.

On connait aussi des résonateurs à ondes élastiques dans lesquels le support de propagation des ondes élastiques est une plaque piézoélectrique mince, plutôt qu'un substrat épais. Une telle plaque peut alors servir de support à la propagation d'ondes dites « de plaque », telles que des ondes de Lamb. Ces ondes élastiques se propagent elles aussi parallèlement à la surface de la plaque. Un résonateur à ondes de plaques peut alors être réalisé, par exemple, en déposant des électrodes métalliques sur une des faces de cette plaque pour réaliser deux réflecteurs, tels que ceux mentionnés ci-dessus.

Les résonateurs à ondes élastiques de surface ou à ondes de plaque ont typiquement des fréquences de résonance comprises entre quelques dizaines de MégaHertz et quelques GigaHertz, bien adaptées à de nombreuses applications de communication par ondes radio (téléphonie mobile, WiFi, Bluetooth, etc...). De plus, ces résonateurs ont généralement des facteurs de qualité élevés et peuvent être intégrés sur des puces électroniques de petites dimensions.

Pour plusieurs types d'applications, notamment dans le domaine des communications radio, il est intéressant de pourvoir ajuster à volonté la fréquence de résonance d'un tel résonateur.

En effet, suite au fort développement des communications radio, les effets de saturation et d'encombrement du spectre radio tendent à se multiplier, d'autant que les bandes de fréquences allouées pour tel ou tel type de protocole sont généralement fixes. Une gestion des communications radios plus agile, dans laquelle les fréquences de communication employées pourraient être modifiées, permettrait de résoudre en partie ce problème. Par ailleurs, les terminaux de téléphonie mobile de dernière génération sont à présent capables d'opérer sur une quarantaine de bandes de fréquences différentes, ce qui nécessite des circuits de traitement des données extrêmement complexes afin de pourvoir à tous les cas de figure. Disposer de composants dont la fréquence de fonctionnement pourrait être pilotée électroniquement permettrait certainement de simplifier ces architectures.

Un résonateur à ondes élastiques de surface, tel que décrit plus haut, et dont la fréquence de résonance est réglable, est décrit dans l'article suivant : P.S. Cross et al., « Electronically variable surface-acoustic-wave velocity and tunable SAW resonators », Appl. Phys. Lett. 28, 1 (1976).

Ce résonateur comprend les deux réflecteurs mentionnés plus haut, et, entre ces deux réflecteurs, un transducteur d'entrée et un transducteur de sortie pour interfacer électriquement le résonateur (ce dispositif fonctionnant en transmission, avec un port d'entré et un port de sortie pour le signal électrique). Le résonateur comprend en outre un transducteur de pilotage de fréquence, situé lui aussi entre les deux réflecteurs et, comprenant deux électrodes métalliques formant deux peignes interdigités. Un condensateur de capacité variable est connecté entre ces deux électrodes. La fréquence de résonance du dispositif (fréquence de résonance électrique, correspondant ici à un maximum de transmission) peut alors être ajustée en faisant varier la capacité de ce condensateur.

La variation de la fréquence de résonance du dispositif, en fonction de la capacité électrique connectée entre ces deux électrodes, peut s'expliquer en remarquant qu'une onde élastique de surface, qui se propage à la surface d'un matériau piézoélectrique, possède une composante électrique. Imposer des conditions particulières au champ électrique, à la surface de ce matériau, influe alors sur la propagation de ces ondes élastiques, cet effet étant généralement appelé effet acousto-électrique.

Ainsi, lorsque la surface du matériau est entièrement métallisée, par exemple, on obtient une vitesse de propagation plus faible que lorsque cette surface est laissée libre électriquement (c'est-à-dire lorsque le champ électrique n'est pas contraint). Le condensateur mentionné plus haut, dont l'impédance peut être réglée, permet alors, dans la zone occupée par le transducteur de pilotage, d'ajuster la vitesse effective des ondes élastiques entre leur vitesse en condition de court-circuit et leur vitesse en condition de circuit ouvert, ce qui permet de modifier la fréquence de résonance du résonateur.

Toutefois, avec le dispositif décrit dans cet article, la plage sur laquelle la fréquence de résonance peut être ajustée reste limitée (cette plage à une largeur valant environ 0,1% de la fréquence de résonance).

JP 2015 144418 A décrit un résonateur SAW accordable comportant un unique IDT d'interfaçage et un unique IDT de pilotage, réalisés de façon entrelacée dans une même région. Le réglage de fréquence s'effectue à l'aide d'une impédance variable.

US 6 160 339 A concerne un filtre SAW de type DMS à trois IDT, non accordable, dans lequel des pistes de connexion sinueuses et non chevauchantes sont disposées sur le substrat pour relier plusieurs IDT d'entrée et de sortie.

### RESUME

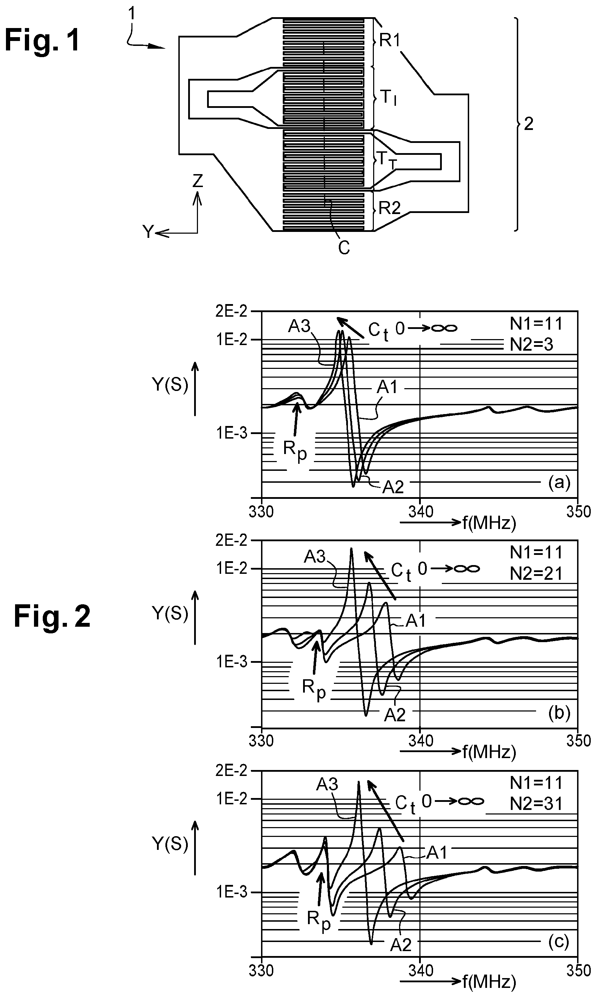

Pour obtenir une plage de réglage plus étendue, une possibilité est d'augmenter le nombre de doigts (ou, en d'autres termes, le nombre de dents) des électrodes interdigitées du transducteur de pilotage de fréquence (tout en conservant la même période entre doigts). Dans le résonateur, cela permet en effet d'augmenter la longueur de la zone occupée par le transducteur de pilotage, et donc la longueur de la zone où la vitesse de propagation est modifiée. Les résultats de simulations représentés sur la figure 2 (qui sera décrite en détail plus loin) montrent d'ailleurs que la largeur de la plage d'accordabilité augmente effectivement lorsque le nombre de doigts N2 des électrodes interdigitées du transducteur de pilotage de fréquence T_{T} augmente.

Augmenter ce nombre de doigts N2 (ainsi éventuellement que le nombre de doigts N1 du transducteur d'interfaçage T_{I} qui sert à interfacer électriquement le résonateur), permet en outre d'obtenir une impédance relativement proche de 50 Ohms, pour l'ensemble de ces transducteurs.

Les inventeurs ont toutefois constaté que l'augmentation du nombre de doigts N2 s'accompagne d'effets indésirables. En particulier, lorsque N2 augmente, une résonance parasite de fréquence fixe (repérée par le signe de référence Rp, sur la figure 2) prend de plus en plus d'importance. Cet effet peut s'expliquer par une augmentation du coefficient de réflexion pour les ondes acoustiques à l'interface entre le transducteur d'interfaçage T_{I} et le transducteur de pilotage T_{T}, lorsque N2 augmente. Cette réflexion plus forte au niveau de cette interface tend alors à favoriser un mode de résonance localisé sur une partie seulement du résonateur, entre le réflecteur R1 et l'interface T_{I}/T_{T} (mode qui est donc localisé principalement au niveau du transducteur d'interfaçage T_{I}). Cet effet parasite peut s'avérer particulièrement gênant. Par exemple, pour les courbes correspondant au cas N1=11 et N2=31, on voit sur la figure 2 que cette résonance parasite Rp a une amplitude aussi grande que la résonance « principale » de fréquence ajustable (en tout cas pour les petites valeurs de capacité).

Dans ce contexte, on propose un dispositif électromécanique comprenant un résonateur à ondes élastiques qui, de manière remarquable, comporte plusieurs transducteurs d'interfaçage, à électrodes interdigitées, ainsi que plusieurs transducteurs de pilotage de fréquence, également à électrodes interdigitées, ces différents transducteurs étant disposés le long d'un chemin de propagation des ondes élastiques en alternant transducteur d'interfaçage, et transducteur de pilotage, le long de ce chemin.

Ainsi plutôt que d'employer un seul transducteur d'interfaçage comportant un grand nombre de doigts, et, à la suite de celui-ci, un seul transducteur de pilotage de fréquence (relié à une impédance externe réglable), comportant lui aussi un grand nombre de doigts disposés les uns à la suite des autres, on utilise ici une multitude de transducteurs de connexion et une multitude de transducteurs de pilotage comportant chacun un nombre de doigts limité, alternés les uns avec les autres le long du chemin de propagation des ondes élastiques.

Cela permet de répartir les électrodes qui contrôlent la vitesse de propagation sur l'ensemble de la longueur du résonateur (pour obtenir une plage de réglage de la fréquence de résonance large), et cela permet aussi d'employer un nombre total de doigts important (pour obtenir une impédance proche de 50 Ohms, par exemple), tout en limitant l'apparition de modes résonants parasites qui seraient localisés sur une partie seulement du résonateur.

En d'autres termes, on favorise ainsi un mode résonant global, réparti sur l'ensemble du résonateur.

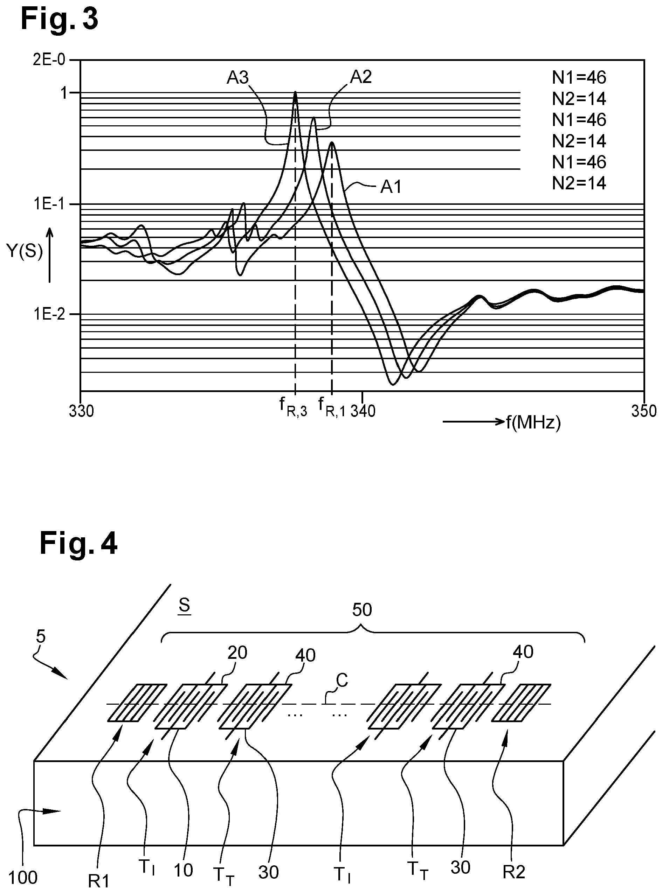

L'amélioration permise par cet agencement particulier est illustré, pour un exemple de réalisation, par la figure 3. Cette figure montre des courbes de résonance électrique obtenues pour un dispositif similaire à celui des figures 1 et 2, mais comportant trois transducteurs de connexion et trois transducteurs de pilotage de fréquence, alternés les uns avec les autres le long du chemin de propagation des ondes élastiques. Comme on peut le voir sur cette figure, cette configuration à transducteurs alternés permet d'obtenir une résonance principale, de fréquence réglable, dont l'amplitude est nettement plus grande que celle des résonances parasites mentionnées précédemment.

La présente technologie concerne plus précisément un dispositif électromécanique ayant une fréquence de résonance ajustable, comprenant :
- un support piézo-électrique délimité par une surface, ou par deux surfaces parallèles entre elles, et
- réalisé sur ce support, un résonateur pour des ondes élastiques se propageant parallèlement à ladite ou auxdites surfaces, le résonateur comprenant au moins :
   - deux réflecteurs qui délimitent le résonateur et qui sont réfléchissants pour lesdites ondes, et
   - entre les deux réflecteurs, plusieurs transducteurs d'interfaçage configuré pour générer lesdites ondes à partir d'un signal électrique, et
   - plusieurs transducteurs de pilotage de ladite fréquence de résonance,
   - chacun desdits transducteurs comprenant une première électrode et une deuxième électrode interdigitées, réalisées chacune sur ladite surface, ou sur l'une desdites surfaces du support piézoélectrique, et
- un dispositif électrique de pilotage de ladite fréquence de résonance, ce dispositif électrique comprenant une première borne et une deuxième borne et présentant entre ces deux bornes une impédance électrique réglable,
- et dans lequel, pour chaque transducteur de pilotage, la première électrode et la deuxième électrode du transducteur sont connectées respectivement à la première borne et à la deuxième borne dudit dispositif électrique de pilotage,
- les premières électrodes des différents transducteurs d'interfaçage sont reliées électriquement les unes aux autres, et les deuxièmes électrodes des transducteurs d'interfaçage sont également connectées électriquement les unes aux autres, et dans lequel
- les transducteurs d'interfaçage et les transducteurs de pilotage sont disposés le long d'un chemin de propagation suivi par lesdites ondes dans le résonateur avec une alternance entre transducteurs d'interfaçage et transducteur de pilotages, chaque transducteur de pilotage étant intercalé entre deux transducteurs d'interfaçage successifs, ou entre l'un des réflecteurs et le transducteur d'interfaçage adjacent.

Les ondes en question peuvent être des ondes de surface se propageant à la surface du support (par exemple de type ondes de Rayleigh), ce support étant alors relativement épais. Dans ce cas, les différentes électrodes des transducteurs ainsi que les réflecteurs sont réalisés sur une même surface, correspondant par exemple à une surface libre du support.

Le support piézo-électrique peut aussi être réalisé sous la forme d'une plaque piézo-électrique mince délimitée par les deux surfaces mentionnées plus haut, l'une supérieure et l'autre inférieure, parallèles entre elles (en pratique, parallèles à mieux que 10 degrés près). Dans ce cas, la déformation causée par le passage des ondes élastiques se répartit sur toute l'épaisseur de la plaque, ou tout au moins sur la majeure partie de son épaisseur. Ces ondes élastiques, par exemple du type ondes de Lamb, sont alors appelées ondes de plaque.

Lorsque le support piézo-électrique est réalisé sous la forme d'une plaque mince, on peut placer certaines électrodes des transducteurs sur l'une des deux surfaces de la plaque, les autres électrodes étant situées sur l'autre surface de cette plaque. Par ailleurs, un support de ce type permet généralement d'obtenir un couplage électromécanique plus fort qu'un support massif (épais) destiné à la propagation d'ondes de surface. La plaque mince mentionnée ci-dessus peut être réalisée sous la forme d'une membrane suspendue, ou, dans un empilement de plusieurs couches, sous la forme d'une couche piézo-électrique où les ondes élastiques restent guidées.

Dans un cas comme dans l'autre (qu'il s'agisse d'ondes de surface ou d'ondes de plaque), le support peut être d'un seul tenant, formé d'un même matériau piézoélectrique, par exemple un matériau monocristallin ou essentiellement monocristallin (tel que du quartz, du niobate de lithium ou du tantalate de lithium). Mais ce support peut aussi être réalisé sous la forme d'un empilement de couches, une ou plusieurs de ces couches (mais pas forcément toutes) étant piézoélectriques.

Le chemin de propagation est la ligne moyenne suivie par les ondes élastiques dans le résonateur. Lorsque le résonateur comprend exactement deux réflecteurs situés en vis-à-vis l'un de l'autre, ce chemin de propagation est un segment qui s'étend de l'un des réflecteurs jusqu'à l'autre.

En pratique, pour régler la fréquence de résonance du résonateur, on connecte l'impédance électrique réglable, par exemple un condensateur de capacité réglable, entre les premières et deuxièmes électrodes des transducteurs de pilotage de fréquence, comme indiqué plus haut. Comme la fréquence de résonance du dispositif est élevée, les valeurs de capacité employées sont généralement petites, de l'ordre du picofarad. Dans ce contexte, la connexion des premières électrodes les unes avec les autres, et la connexion des deuxièmes électrodes les unes avec les autres doit être particulièrement soignée pour éviter d'introduire des impédances parasites additionnelles, en particulier des capacités parasites. En particulier, une connexion entre électrodes au moyen de fils soudés sur les électrodes (connexion de type « wire bonding ») n'est généralement pas optimale, dans ce contexte.

Aussi, pour limiter l'apparition de telles impédances parasites, il est prévu que :
- pour au moins certains des transducteurs d'interfaçage, voir pour tous:
   - les premières électrodes de ces transducteurs d'interfaçage sont connectées les unes aux autres par une ou plusieurs premières pistes électriques, et
   - les deuxièmes électrodes de ces transducteurs d'interfaçage sont connectées les unes aux autres par une ou plusieurs deuxièmes pistes électriques, que
- pour au moins certains desdits transducteurs de pilotage, voire pour tous :
   - les premières électrodes de ces transducteurs de pilotage sont connectées les unes aux autres par une ou plusieurs troisièmes pistes électriques, et
   - les deuxièmes électrodes de ces transducteurs de pilotage sont connectées les unes aux autres par une ou plusieurs quatrièmes pistes électriques,
- chacune desdites pistes électriques étant réalisées sur la surface, ou sur l'une des deux surfaces du support piézo-électrique.

Il est prévu en outre que les pistes qui sont réalisées sur la même surface du support piézo-électrique ne se chevauchant pas les unes avec les autres.

Les pistes qui sont réalisées sur la même surface du support ne se chevauchent pas en ce sens qu'elles ne se superposent pas l'une à l'autre et ne passent pas l'une sur l'autre. En d'autres termes, en projection sur cette surface, elles ne se croisent pas (c'est-à-dire qu'elles ne s'intersectent pas, en projection sur cette surface). Différentes caractéristiques, permettant d'éviter un chevauchement entre pistes, sont présentées plus bas.

Outre les caractéristiques présentées ci-dessus, le dispositif électromécanique qui vient d'être décrit peut présenter une ou plusieurs caractéristiques complémentaires parmi les suivantes, considérées individuellement ou selon toutes les combinaisons techniquement possibles :
- chacune desdites électrodes interdigitées comprend un ou plusieurs doigts et une bande longitudinale conductrice à partir de laquelle s'étendent le ou lesdits doigts et qui forme le corps principal de l'électrode ;
- pour les transducteurs d'interfaçage :
   - chacune desdites deuxièmes électrodes comprend au moins un doigt de plus que la première électrode à laquelle elle est associée, les deux doigts périphériques de cette deuxième électrode encadrant l'ensemble des doigts de la première électrode, ces deux doigts périphériques ayant chacun, à l'opposé du corps principal de la deuxième électrode, une extrémité située du premier côté dudit chemin de propagation, et
   - chacune desdites deuxièmes pistes relie l'extrémité de l'un des doigts périphériques d'une desdites deuxièmes électrodes à l'extrémité de l'un des doigts périphériques de la deuxième électrode suivante, les corps principaux desdites deuxièmes électrodes et leurs doigts périphériques formant, avec les deuxièmes pistes, une piste globale qui serpente le long du chemin de propagation, de part et d'autre dudit chemin, en contournant les transducteurs de pilotage;
- pour chaque transducteur d'interfaçage, le corps principal de la deuxième électrode du transducteur est relié à l'une desdites deuxièmes pistes, non seulement par l'un des doigts périphériques de cette deuxième électrode mais aussi par un ou plusieurs doigts supplémentaires qui s'étendent transversalement par rapport au chemin de propagation, en traversant le chemin de propagation et qui sont situés entre le transducteur d'interfaçage considéré et l'un des transducteurs de pilotage, adjacent ;
- chacune desdites deuxièmes pistes forme, avec la deuxième électrode de l'un des transducteur de pilotage, une même bande longitudinale conductrice située du premier côté du chemin de propagation ;
- chacune desdites quatrièmes pistes (42) forme, avec la deuxième électrode (20) de l'un des transducteur d'interfaçage (TI) une même bande longitudinale conductrice située du deuxième côté du chemin de propagation ;
- les deuxièmes électrodes des transducteurs d'interfaçage sont en contact électrique avec les deuxièmes électrodes des transducteurs de pilotage, au moins par l'intermédiaire de leurs doigts périphériques, les corps principaux des deuxièmes électrodes et leurs doigts périphériques formant ensemble une même piste principale qui serpente le long du chemin de propagation, de part et d'autre dudit chemin, en contournant les premières électrodes des transducteurs de pilotage et des transducteurs d'interfaçage ;
- les premières et deuxièmes pistes électriques sont situées d'un premier côté du chemin de propagation des ondes élastiques, tandis que les troisièmes et quatrièmes pistes électriques sont situés d'un deuxième côté, opposé, du chemin de propagation des ondes élastiques ;
- pour les transducteurs d'interfaçage :
   - le corps principal de chacune desdites premières électrodes est situé du premier côté du chemin de propagation, et le corps principal de chacune desdites deuxièmes électrodes est situé du deuxième côté du chemin de propagation, et
   - chacune desdites premières pistes relie le corps principal de l'une des premières électrodes au corps principal de la première électrode suivante ;
- ledit support forme une plaque mince, délimitée par lesdites deux surfaces, parallèles entre elles ; cette plaque, par exemple suspendue, peut être au moins partiellement libre de se déformer selon une direction perpendiculairement à la plaque ;
- les transducteurs d'interfaçage et les transducteurs de pilotage sont réalisés sur la même surface dudit support ;
- les transducteurs d'interfaçage sont réalisés sur l'une des surfaces de la plaque tandis que les transducteurs de pilotage sont réalisés sur l'autre surface de la plaque ;
- les deuxièmes électrodes des transducteurs d'interfaçage sont en contact électrique avec les deuxièmes électrodes des transducteurs de pilotage, et:
   - soit les premières électrodes des transducteurs d'interfaçage,
   - soit les premières électrodes des transducteurs de pilotage,
   - soit les deuxièmes électrodes des transducteurs d'interfaçage et des transducteurs de pilotage
   sont réalisées sur l'une des surfaces de ladite plaque, les autres électrodes des transducteurs d'interfaçage et des transducteurs de pilotage étant réalisées sur l'autre surface de ladite plaque ;
- les premières et deuxièmes électrodes comprennent chacune un ou plusieurs doigts qui s'étendent transversalement par rapport audit chemin de propagation, et dans lequel, pour au moins certaines des premières et deuxièmes électrodes, voire pour toutes, le nombre total de doigts de l'électrode est inférieur ou égal à 10, voir inférieur ou égal à 5 ou 6.
- pour au moins certaines des premières et deuxièmes électrodes, voire pour toutes, le nombre total de doigts de l'électrode est compris entre 1 et 3, voire entre 1 et 2 ;
- l'ensemble qui regroupe les différentes électrodes des transducteurs de pilotage et des transducteurs d'interfaçage comprend un nombre total de doigts d'électrode supérieur ou égal à 40, voire supérieur ou égal à 80, ou même supérieur à 150 ;
- le nombre de transducteurs d'interfaçage est supérieur ou égal à trois, voire supérieur ou égal à quatre ou à cinq ;
- le nombre de transducteurs de pilotage est supérieur ou égal à trois, voire supérieur ou égal à quatre ou à cinq.

La présente technologie et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif.
[Fig. 1] La figure 1 représente schématiquement un dispositif électromécanique comprenant un résonateur à ondes de surface agile en fréquence, vu de dessus. Ce dispositif est présenté à titre de comparaison, et ne met pas en œuvre la présente technologie, à proprement parler.
[Fig. 2] La figure 2 représente schématiquement des courbes de résonance électrique du dispositif de la figure 1, le nombre de doigts des électrodes de pilotage de fréquence variant d'une configuration à l'autre.
[Fig. 3] La figure 3 représente schématiquement des courbes de résonance électrique d'un dispositif similaire à celui de la figure 1, mais comprenant plusieurs transducteurs d'interfaçage, et plusieurs transducteurs de pilotage de fréquence de résonance s'alternant les uns avec les autres le long de l'axe du résonateur.
[Fig. 4] La figure 4 représente schématiquement un dispositif électromécanique comprenant un résonateur à ondes de surface agile en fréquence, vu en perspective.
[Fig. 5] La figure 5 représente schématiquement le dispositif de la figure 4, vu de dessus.
[Fig. 6] La figure 6 représente schématiquement des courbes de résonance électrique du dispositif de la figure 4.
[Fig. 7] La figure 7 représente schématiquement des courbes de résonance électrique d'un autre dispositif électromécanique agile en fréquence comprenant un résonateur à ondes de surface, qui est représenté sur la figure 8.
[Fig. 8] La figure 8 représente schématiquement un dispositif électromécanique comprenant un résonateur à ondes de surface agile en fréquence, vu de dessus.
[Fig. 9] La figure 9 représente schématiquement encore un autre dispositif électromécanique comprenant un résonateur à ondes de surface agile en fréquence, vu de dessus.
[Fig. 10] La figure 10 représente schématiquement des courbes de résonance électrique du dispositif de la figure 9.
[Fig. 11] La figure 11 représente schématiquement un dispositif électromécanique comprenant un résonateur à ondes de plaque agile en fréquence, vu en perspective.
[Fig. 12] La figure 12 représente schématiquement le dispositif de la figure 11, vu de dessus.
[Fig. 13] La figure 13 représente schématiquement des courbes de résonance électrique du dispositif de la figure 11.
[Fig. 14] La figure 14 représente schématiquement un autre dispositif électromécanique comprenant un résonateur à ondes de plaque agile en fréquence, vu de dessus.
[Fig. 15] La figure 15 représente schématiquement une partie du dispositif de la figure 14, vu en coupe et de côté.
[Fig. 16] La figure 16 représente schématiquement une partie d'un autre dispositif électromécanique comprenant un résonateur à ondes de plaque agile en fréquence, vu en coupe et de côté.

### DESCRIPTION DETAILLEE

La figure 1 représente schématiquement un dispositif électromécanique, 1, comprenant un résonateur à ondes élastiques 2 qui comporte un seul transducteur d'interfaçage T_{I} et un seul transducteur de pilotage de fréquence de résonance, T_{T}. Ce cas est présenté à titre de comparaison, pour mieux illustrer l'intérêt d'équiper un tel résonateur de plusieurs transducteurs d'interfaçage et plusieurs transducteurs de pilotage intercalés les uns avec les autres le long du chemin de propagation C suivi par les ondes élastiques dans le résonateur.

Ce dispositif 1 comprend un substrat piézo-électrique massif en Niobate de Lithium LiNbO₃, en coupe X, qui sert de support à la propagation d'ondes élastiques de surface se propageant à la surface de ce substrat. Le résonateur 2 peut être réalisé en déposant une couche métallique (ici une couche d'Aluminium) sur la surface libre du substrat, puis en réalisant une lithographie et gravure de cette couche de manière à délimiter deux réflecteurs R1 et R2, les électrodes des transducteurs T_{T} et T_{I}, ainsi que des zones de contact permettant de connecter les électrodes à des éléments extérieur, par exemple à un condensateur de capacité réglable (au moyen de fils conducteurs soudés sur ces zones de contact, par exemple).

Les deux réflecteurs R1 et R2 comprennent chacun plusieurs bandes métalliques parallèles, régulièrement espacées pour former un réseau périodique réfléchissant pour les ondes élastiques en question (sorte de miroir de Bragg ; la période, c'est-à-dire le pas de ce réseau est typiquement de λ/2, où λ est la longueur d'onde à résonance attendue pour ce résonateur, par exemple lorsque le transducteur de pilotage est en circuit ouvert). Vu de dessus, chacun de ces réflecteurs peut avoir la forme d'une échelle, chacune des bandes en question formant l'un des barreaux de l'échelle. Ces réflecteurs sont généralement formés de deux électrodes, reliées électriquement l'une à l'autre (court-circuitées). Ils peuvent toutefois également être formés d'électrodes laissées électriquement flottantes (en circuit-ouvert) : dans ce cas le réflecteur prend la forme d'un réseau de périodicité identique de lignes métalliques non reliées entre elles.

Les deux réflecteurs sont situés en vis-à-vis l'un de l'autre. Ils sont situés sur un même axe, en l'occurrence un axe parallèle à l'axe cristallographique Z du substrat. Les bandes métalliques de chacun de ces réflecteurs sont perpendiculaires à cet axe, si bien que chaque réflecteur renvoie les ondes élastiques en direction de l'autre réflecteur. La direction de propagation moyenne des ondes élastiques dans le résonateur 2 est donc celle de l'axe Z. Le chemin de propagation, C, suivi par les ondes élastiques dans le résonateur est un segment délimité par les deux réflecteurs R1 et R2, et donc, ici, parallèle à l'axe Z.

Le transducteur d'interfaçage T_{I} et le transducteur de pilotage T_{T} sont situés tous les deux sur le chemin de propagation C, entre les deux réflecteurs R1, et R2, et l'un à la suite de l'autre. Ces transducteurs T_{I} et T_{T} comprennent chacun une première électrode et une deuxième électrode interdigitées. Chacune de ces électrodes comprend un ou plusieurs doigts parallèles entre eux, et perpendiculaires au chemin de propagation C. Lorsque l'électrode comprend plusieurs doigts, ceux-ci sont agencés de manière à former un peigne. Chaque doigt a alors la forme d'une bande métallique ayant une extrémité libre et, à l'opposé, une extrémité par laquelle il se raccorde à une bande longitudinale commune (perpendiculaire aux doigts), appelée « bus ». Le ou les doigts de la première électrode, et ceux de la deuxième électrode sont intercalés les uns avec les autres. Ils sont agencés, le long du chemin de propagation C, en alternant à chaque fois un doigt de la première électrode puis un doigt de la deuxième électrode et ainsi de suite (ainsi, chaque doigt de la première électrode, sauf éventuellement ceux des extrémités du peigne, s'étend entre deux doigts de la deuxième électrode).

Le nombre total de doigts du transducteur d'interfaçage T_{I}, égal à la somme du nombre de doigts de sa première électrode et du nombre de doigts de sa deuxième électrode, est noté N1. Le nombre total de doigts du transducteur de pilotage T_{T} est noté N2.

Sur la figure 2, on a représenté des courbes de résonance électrique du dispositif 1 de la figure 1, obtenues par simulation numérique, pour les trois configurations suivantes :
- N1=11 et N2=3 (courbes (a), sur la figure 2),
- N1=11 et N2=21 (courbes (b), sur la figure 2), et
- N1=11 et N2=31 (courbes (c), sur la figure 2).

Pour ces trois configurations, on a représenté sur la figure 2 l'admittance Y du dispositif 1 (la quantité Y est plus précisément égale au module de l'admittance en question), entre les deux électrodes du transducteur d'interfaçage T_{I} (l'admittance Y étant exprimée en Siemens), en fonction de la fréquence f (en MégaHertz), les deux électrodes du transducteur de pilotage T_{T} étant quant à elles reliées à un condensateur de capacité Ct réglable.

Pour chacune de ces configurations, on a représenté trois courbes, correspondant respectivement à trois valeurs différentes de la capacité Ct. Sur la figure 2, pour chaque configuration (a), (b) et (c), on a ainsi représenté :
- une première courbe A1 correspondant à une valeur de capacité Ct très faible (cette situation est quasiment équivalente à deux électrodes en circuit ouvert, pour le transducteur de pilotage T_{T}), courbe pour laquelle la fréquence de résonance est la plus grande,
- une deuxième courbe A2 correspondant à une valeur de capacité Ct intermédiaire (environ 0,3 picofarad, l'impédance du condensateur étant alors de l'ordre du kiloOhm), courbe pour laquelle la fréquence de résonance est intermédiaire, et
- une troisième courbe A3 correspondant à une valeur de capacité Ct très grande (cette situation est quasiment équivalente à deux électrodes en court-circuit, pour le transducteur de pilotage T_{T}), situation dans laquelle la fréquence de résonance est la plus petite.

Comme on peut le voir sur cette figure (et comme déjà discuté dans la partie « résumé »), augmenter le nombre de doigts N2 du transducteur de pilotage T_{T} rend le dispositif 1 plus agile : sa fréquence de résonance peut être ajustée sur une plage plus grande (plage d'environ 1 MHz pour N2=3 et d'un peu plus de 2,5 MHz pour N2=31). Mais l'on note aussi l'apparition d'une résonance parasite R_{P} de fréquence fixe, d'autant plus marquée que N2 est grand. Pour N2 = 31, par exemple, en situation de circuit ouvert (courbe A1), cette résonance parasite a une amplitude aussi grande que la résonance principale de fréquence réglable, et est donc particulièrement gênante. Comme déjà indiqué, cette résonance parasite (qui se produit pour une fréquence d'environ 334 Mégahertz) est associée à un mode résonant localisé sur une partie seulement du résonateur 2 et correspondant en quelque sorte à une résonance acoustique propre de la partie occupée par le transducteur d'interfaçage T_{I} (ce qui explique que cette résonance parasite R_{P} ait une fréquence fixe, indépendante de l'impédance connectée entre les électrodes du transducteur de pilotage T_{T}).

Sur la figure 3, on a représenté des courbes de résonance électrique d'un dispositif similaire à celui de la figure 1, mais comprenant trois transducteurs d'interfaçage et trois transducteurs de pilotage de fréquence, alternés les uns avec les autres le long du chemin de propagation des ondes élastiques.

Chacun de ces transducteurs comprend une première électrode et une deuxième électrode interdigitées, telles que décrites ci-dessus. Pour chaque transducteur d'interfaçage, le nombre total de doigts du transducteur, N1, est égal à 46, ici (il s'agit de la somme du nombre de doigts de sa première électrode et du nombre de doigts de sa deuxième électrode). Et, pour chaque transducteur de pilotage, le nombre total de doigts du transducteur, N2, est ici égal à 14.

Les premières électrodes des trois transducteurs de pilotage sont reliées électriquement entre elles. Les deuxièmes électrodes des trois transducteurs de pilotage sont aussi reliées électriquement entre elles, et un condensateur de capacité électrique réglable est connecté entre ces premières électrodes d'une part, et ces deuxièmes électrodes d'autre part.

Les premières électrodes des trois transducteurs d'interfaçage sont reliées électriquement entre elles, de même que les deuxièmes électrodes de ces transducteurs. Sur la figure 3, on a représenté l'admittance Y du dispositif (en Siemens), entre ces premières électrodes d'une part, et ces deuxièmes électrodes d'autre part, en fonction de la fréquence f (en MégaHertz). Trois courbes, A1, A2 et A3 (obtenues là aussi par simulations numériques), correspondant aux trois valeurs de capacités mentionnées précédemment (capacité très faible, capacité intermédiaire, d'environ 0,3 picofarad, et capacité très grande), sont représentées sur la figure 3.

Comme on peut le voir sur la figure 3, employer plusieurs transducteurs de pilotage répartis sur l'ensemble du chemin de propagation et intercalés entre les transducteurs d'interfaçage (plutôt qu'un unique transducteur de pilotage plus long, d'un seul tenant), permet d'obtenir une résonance principale de fréquence réglable, dont l'amplitude est marquée et est nettement plus grande que celle des résonances parasites que l'on peut observer sur cette figure. Pour la courbe A1, la fréquence pour laquelle la résonance est obtenue est repérée par la référence f_{R,1}, sur la figure 3. Et pour la courbe A3, la fréquence laquelle la résonance est obtenue est repérée par la référence f_{R,3}. Pour chacune de ces courbes, on remarque aussi que la résonance est particulièrement bien séparée de l'antirésonance, ce qui montre un coefficient de couplage électromécanique fort.

Comme déjà expliqué, une telle configuration, dans laquelle on alterne transducteur d'interfaçage et transducteur de pilotage, permet de répartir les électrodes qui contrôlent la vitesse de propagation sur l'ensemble du résonateur (pour obtenir une plage de réglage de la fréquence de résonance large), et permet, pour l'ensemble des transducteurs, d'employer un nombre total de doigts important (pour obtenir une impédance proche de 50 Ohms, par exemple), tout en limitant l'apparition de modes résonants parasites localisés sur une partie seulement du résonateur.

D'ailleurs, de manière générale, la présente technologie concerne un dispositif électromécanique 5 ; 8 ; 9 ; 12 ; 14 ; 16 ayant une fréquence de résonance ajustable, et comprenant :
- un support 100 ; 200, piézoélectrique, délimité par une surface S, ou par deux surfaces S1 et S2 parallèles entre elles, et
- réalisé sur ce support 100 ; 200, un résonateur 50 ; 80 ; 90 ; 120 ; 140pour des ondes élastiques se propageant parallèlement à ladite ou auxdites surfaces S ; S1, S2, le résonateur comprenant :
   - deux réflecteurs R1 et R2 qui délimitent le résonateur et qui sont réfléchissants pour lesdites ondes,
   - plusieurs transducteurs d'interfaçage T_{I}, et
   - plusieurs transducteurs de pilotage T_{T} de ladite fréquence de résonance,
   les transducteurs d'interfaçage T_{I} et les transducteurs de pilotage T_{T} étant disposés le long d'un chemin de propagation C suivi par lesdites ondes dans le résonateur, avec, le long de ce chemin de propagation, une alternance entre transducteurs d'interfaçage et transducteurs de pilotage.

Les transducteurs d'interfaçage T_{I} et les transducteurs de pilotage T_{T} sont disposés les uns à la suite des autres le long du chemin de propagation C, avec, successivement, un transducteur d'interfaçage T_{I}, puis un transducteur de pilotage T_{T}, puis un transducteur d'interfaçage Ti, et ainsi de suite. Ainsi, sauf pour les deux transducteurs (T_{I}, ou T_{T}) situés aux deux extrémités du chemin de propagation C, chaque transducteur de pilotage T_{T} est intercalé entre deux transducteurs d'interfaçage T_{I} (qui sont ses plus proches voisins), et, de même, chaque transducteur d'interfaçage T_{I} est intercalé entre deux transducteurs de pilotage T_{T} (qui sont ses plus proches voisins). Quant aux deux transducteurs, T_{I} ou T_{T}, situés aux deux extrémités du chemin de propagation C, ils sont intercalés chacun entre l'un des deux réflecteurs R1, R2 d'une part, et un transducteur d'un autre type, T_{T} ou T_{I}, d'autre part.

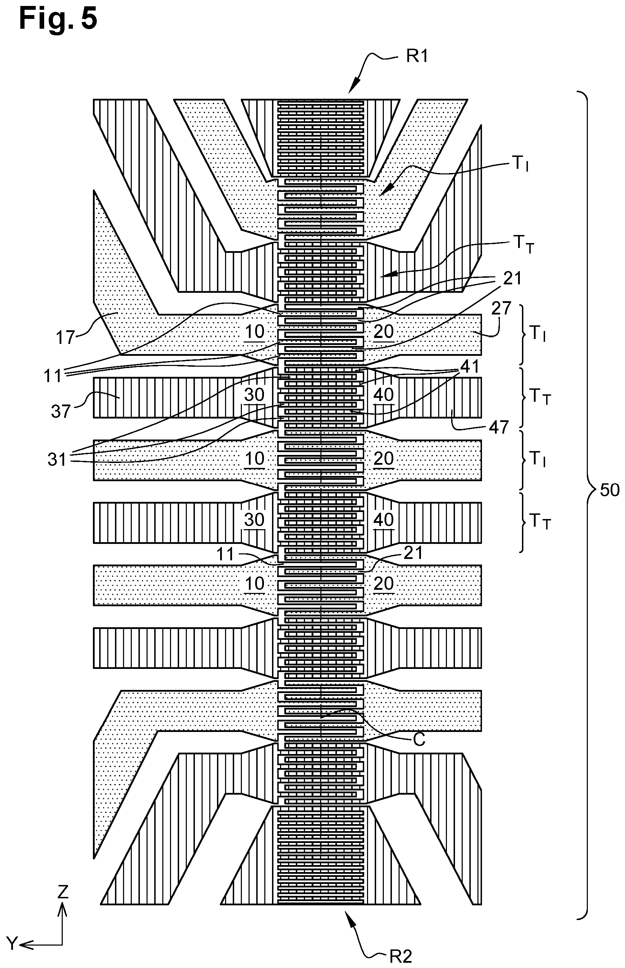

En plus du mode de réalisation correspondant aux courbes de résonances de la figure 3, six modes de réalisation différents de ce dispositif 5 ; 8 ; 9 ; 12 ; 14 et 16 sont décrits ici. Ils sont représentés respectivement sur les figures 5, 8, 9, 12, 14 et 16.

Pour les modes de réalisation des figures 5, 8 et 9, le support 100 du dispositif est un support massif, épais, et le résonateur 50 ; 80 ; 90 est un résonateur à ondes de surface, réalisé sur la surface libre S de ce support (voir la figure 4). Ici, cette surface est plane.

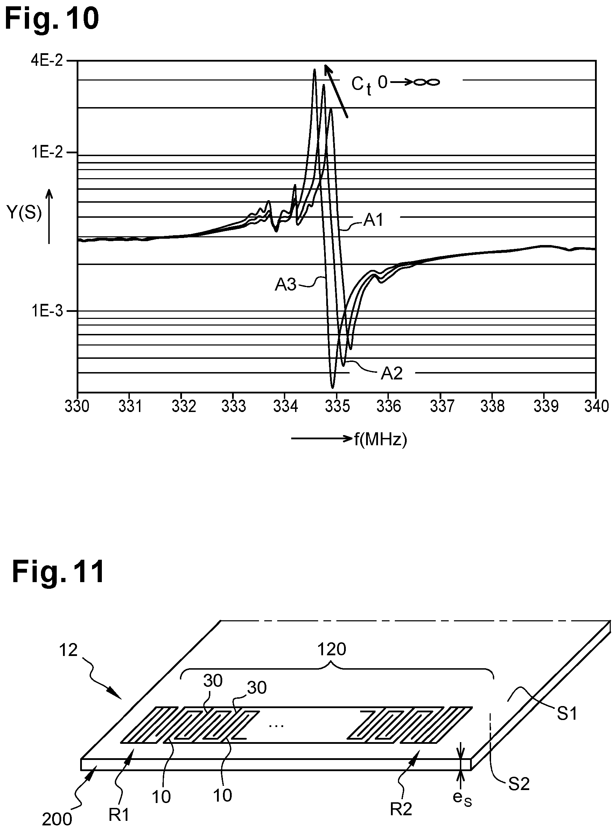

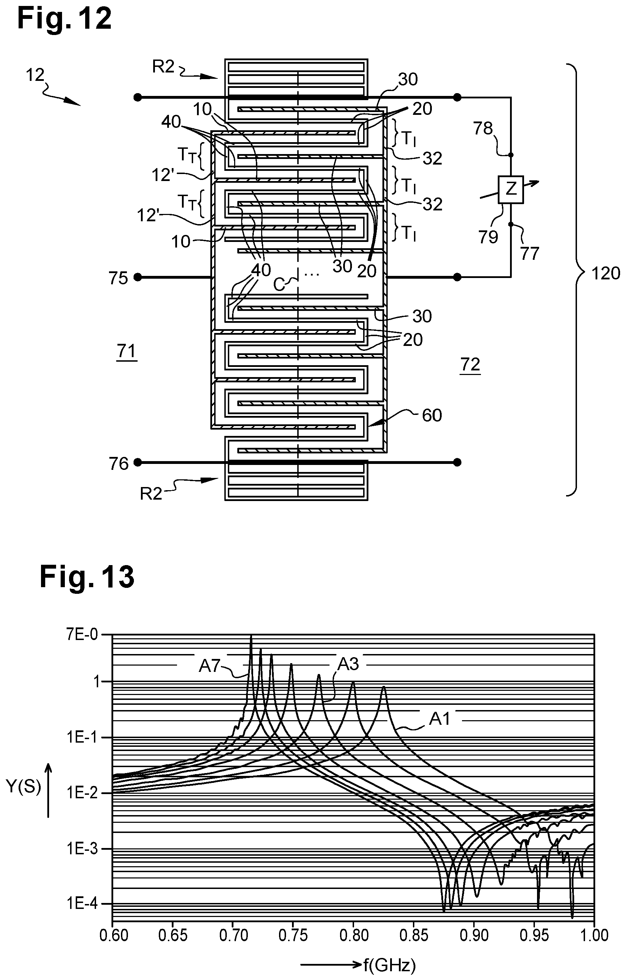

Pour les trois autres modes de réalisation, des figures 12, 14 et 16, le support, 200, est une plaque piézoélectrique mince (voir la figure 11), délimitée par les deux surfaces S1 et S2 mentionnées plus haut, et le résonateur est un résonateur à ondes de plaques. Les deux surfaces S1 et S2 sont planes, ici.

Ces différents modes de réalisation présentent de nombreux points communs. Aussi, d'un mode de réalisation à l'autre, les éléments identiques ou correspondant seront autant que possible repérés par les mêmes signes de référence, et ne seront pas nécessairement décrits à chaque fois.

Des caractéristiques communes à ces différents modes de réalisation sont présentées tout d'abord, avant de décrire plus en détail chacun de ces modes de réalisation, l'un après l'autre.

Dans chacun de ces modes de réalisation, le résonateur comprend exactement deux réflecteurs. Ces deux réflecteurs R1 et R2 ont une structure similaire, voir identique aux résonateurs de la figure 1 : ils comprennent chacun plusieurs bandes métalliques parallèles, régulièrement espacées pour former un réseau périodique réfléchissant pour les ondes élastiques considérées. Ces deux réflecteurs sont situés en vis-à-vis l'un de l'autre, sur un même axe. Dans le résonateur, les ondes élastiques se propagent le long de cet axe, en se réfléchissant alternativement sur l'un, puis sur l'autre de ces réflecteurs R1 et R2. Le chemin de propagation, C, suivi par les ondes élastiques dans le résonateur est un segment délimité par les deux réflecteurs R1 et R2.

Pour ce qui est des transducteurs d'interfaçage T_{I}, ils comprennent chacun une première électrode 10 et une deuxième électrode 20 interdigitées, réalisées chacune sur la surface S du support (figure 4), ou l'une des deux surfaces S1 ou S2 du support 200, lorsque ce support est réalisé sous la forme d'une plaque mince.

De même, chaque transducteur de pilotage T_{T} comprend une première électrode 30 et une deuxième électrode 40 interdigitées, réalisées chacune sur la surface S du support (figure 4), ou l'une des deux surfaces S1 ou S2 du support 200.

Ces électrodes 10, 20, 30, 40 comprennent chacune un ou plusieurs doigts 11, 21, 31, 41 parallèles entre eux, et perpendiculaires au chemin de propagation C. Lorsque l'électrode comprend plusieurs doigts, ceux-ci sont agencés de manière à former un peigne. Chaque doigt 11, 21, 31, 41 forme alors une bande métallique ayant une extrémité libre et, à l'opposé, une extrémité par laquelle il se raccorde à une bande longitudinale commune aux différents doigts de ce peigne (perpendiculaire aux doigts), qui forme le corps principal de l'électrode (corps principal du peigne), appelé « bus ». Le ou les doigts de la première électrode 10, 30 et ceux de la deuxième électrode 20, 40 sont intercalés les uns avec les autres : ils sont agencés, le long du chemin de propagation C, en alternant à chaque fois un doigt 11, 31 de la première électrode 10, 30 puis un doigt 21, 41 de la deuxième électrode 20, 40 et ainsi de suite.

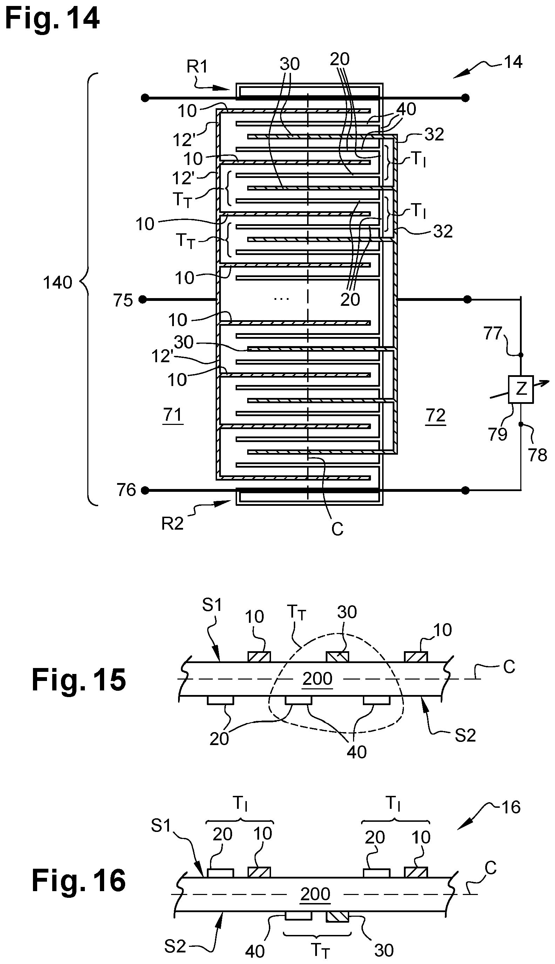

On notera que les première et deuxième électrodes d'un même transducteur peuvent comprendre chacune un seul doigt, dans certains cas (cas du dispositif de la figure 16, par exemple). Par ailleurs, les première et deuxième électrodes d'un même transducteur peuvent être réalisées sur deux surfaces différentes du support 200 (voir la figure 15, par exemple).

Les critères qui conduisent à choisir un nombre de doigts par électrode plus ou moins élevé sont discutés plus bas, après la description des figures en elles-mêmes.

Le dispositif électromécanique 5 ; 8 ; 9 ; 12 ; 14 ; 16 est configuré de sorte que chaque transducteur d'interfaçage T_{I} puisse être alimenté électriquement, ou connecté électriquement à un élément extérieur au dispositif, indépendamment des transducteurs de pilotage T_{T}. Quant aux transducteurs de pilotage T_{T}, ils sont connectés (indépendamment des transducteurs d'interfaçage) à un dispositif électrique 79 d'impédance électrique réglable, qui appartient au dispositif électromécanique 5 ; 8 ; 9 ; 12 ; 14 ; 16.

Ainsi, pour chaque transducteur d'interfaçage T_{I}, l'une au moins des deux électrodes du transducteur est isolée électriquement vis-à-vis des différentes électrodes des transducteurs de pilotage T_{T} (pour pouvoir alimenter/connecter ce transducteur T_{I} indépendamment des transducteurs de pilotage T_{T}). De même, pour chaque transducteur de pilotage T_{T}, l'une au moins des deux électrodes du transducteur est isolée électriquement vis-à-vis des différentes électrodes des transducteurs d'interfaçage T_{I}.

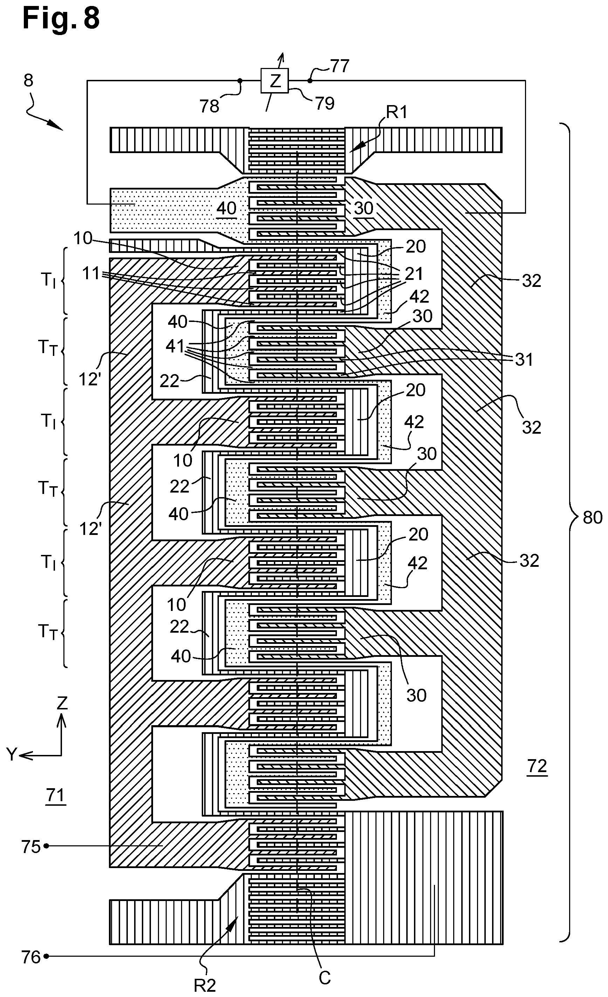

Dans les modes de réalisation décrits ici, les première électrodes 10 des différents transducteurs d'interfaçage T_{I} sont reliées électriquement les unes aux autres (c'est-à-dire reliée directement, par un conducteur électrique, sans composant électrique intermédiaire). Les premières électrodes 10 sont reliées électriquement à une première borne de connexion du dispositif électromécanique, 75 (voir la figure 8, par exemple). Les deuxièmes électrodes 20 des différents transducteurs d'interfaçage T_{I} sont elles aussi reliées électriquement les unes aux autres. Elles sont reliées électriquement à une deuxième borne de connexion du dispositif électromécanique, 76. Les deux bornes 75 et 76 permettent de connecter le dispositif électromécanique à un élément extérieur. Elles permettent par exemple de connecter le dispositif électromécanique (qui sert de résonateur électrique accordable) dans un circuit électronique complet, par exemple un circuit de filtrage agile en fréquence, ou un circuit de génération de signaux, de fréquence ajustable. En pratique, les deux bornes de connexion 75 et 76 peuvent correspondre directement à deux pistes électriques larges, ou à deux zones de connexion (« pads » de connexion, en anglais) réalisées sur la surface S, ou sur l'une des surfaces S1, S2 du support 100 ; 200.

Les première électrodes 30 des différents transducteurs de pilotage T_{T} sont elles aussi reliées électriquement les unes aux autres. Elles sont reliées à une première borne 77 du dispositif 79 d'impédance Z réglable (voir la figure 8, par exemple). Les deuxièmes électrodes 40 des différents transducteurs de pilotage T_{T} sont elles aussi reliées électriquement les unes aux autres. Elles sont reliées électriquement à une deuxième borne 78 du dispositif 79. Le dispositif 79 a, entre ses bornes 77 et 78, une impédance électrique Z réglable (par exemple pilotable électriquement). D'un point de vue électrique, le dispositif 79 peut en particulier être équivalent à un condensateur de capacité électrique réglable (il peut d'ailleurs s'agir d'un condensateur de capacité réglable).

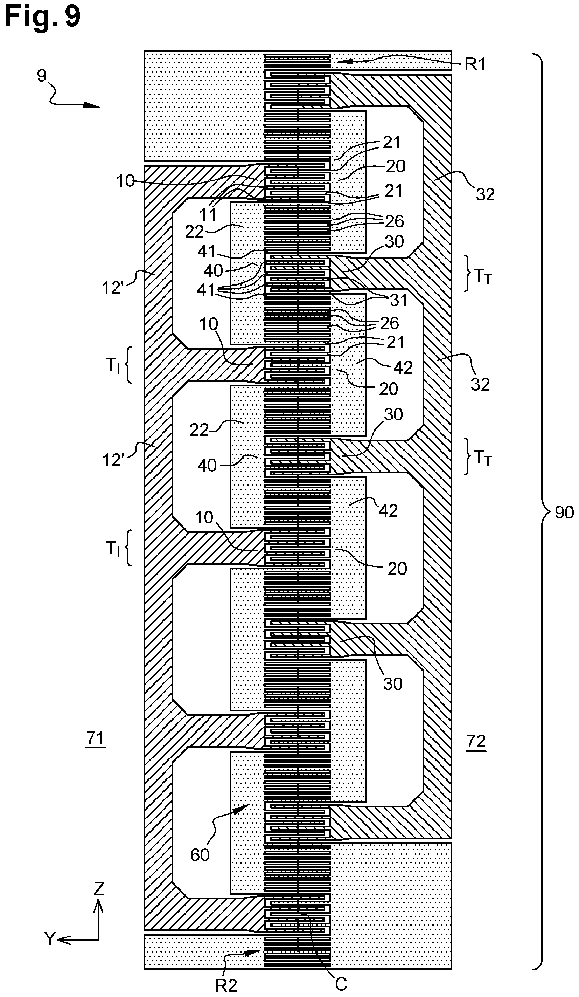

On notera que, dans certains modes de réalisation (modes de réalisation des figures 9 et 12, par exemple), à masse électrique commune, les deuxièmes électrodes 40 des transducteurs de pilotage T_{T} sont reliées électriquement aux deuxièmes électrodes 20 des transducteurs d'interfaçage T_{I} (les électrodes 40 et 20 sont court-circuitées les unes avec les autres). Les premières électrodes 30 des transducteurs de pilotage T_{T} restent néanmoins isolées électriquement des premières électrodes 10 des transducteurs d'interfaçage T_{I}, dans ce cas.

### Résonateurs à ondes de surface

Les trois premiers modes de réalisation du dispositif électromécanique 5 ; 8 ; 9, dans le lequel le résonateur est un résonateur à ondes de surface, sont décrits maintenant plus en détail.

Comme déjà indiqué, dans ces trois modes de réalisation, le support 100 est un support massif, épais (dont l'épaisseur est par exemple supérieure ou égale à 6 fois la longueur d'onde de l'onde acoustique employée à la fréquence de travail, c'est-à-dire supérieure ou égale à 12 fois la période des électrodes utilisées dans le dispositif électromécanique). En l'occurrence, le support 100 est en Niobate de Lithium LiNbO₃, en coupe X (c'est-à-dire que la surface libre S est orthogonale à l'axe cristallographique X). Par ailleurs, l'axe du résonateur, c'est-à-dire l'axe de propagation des ondes élastiques, dans le résonateur, est parallèle à l'axe cristallographique Z (autrement dit, le chemin de propagation C est parallèle à l'axe Z).

Les réflecteurs R1, R2 et les électrodes 10, 20, 30, 40 des différents transducteurs T_{T}, T_{I} sont réalisés dans un matériau conducteur, par exemple un matériau métallique. Ici, elles sont réalisées en aluminium. Leur épaisseur (extension perpendiculairement à la surface S) est comprise typiquement entre 0,02 et 1,5 microns ; Ici, par exemple, elle est de 0,7 microns. Les transducteurs et les réflecteurs sont réalisés avec un rapport de métallisation compris par exemple entre 20 et 60 %. Ici, par exemple, le rapport de métallisation est de 50%. Le rapport de métallisation est égal à :
- la largeur de l'un quelconque des doigts 11, 21, 31, 41 d'électrode interdigitée (c'est-à-dire l'extension du doigt, parallèlement au chemin de propagation C), divisé par
- le pas (période spatiale) entre deux doigts successifs.

Ici, par exemple, chaque doigt a une largeur de 2,5 microns, et l'espace laissé libre entre deux doigts successifs a lui aussi une largeur de 2,5 microns (taux de métallisation de 50%). Le pas en question est donc égal à 5 microns. Et la période spatiale entre deux doigts successifs *d'une même électrode* est de 10 microns.

Dans le premier mode de réalisation, représenté sur les figures 4 et 5, le résonateur 50 du dispositif électromécanique 5 comprend cinq transducteurs d'interfaçage T_{I} et cinq transducteurs de pilotage de fréquence T_{T}. Pour chaque transducteur d'interfaçage T_{I}, la première électrode 10 du transducteur comprend quatre doigts, 11, tandis que la deuxième électrodes 20 comprend cinq doigts, 21. De même, pour chaque transducteur de pilotage T_{T}, la première électrode 30 du transducteur comprend quatre doigts 31, tandis que la deuxième électrodes 40 comprend cinq doigts, 41. L'ensemble de transducteurs comprend ainsi 90 doigts, répartis régulièrement (périodiquement) le long du chemin de propagation C des ondes élastiques.

Chacune des électrodes 10, 20, 30 et 40 se prolonge, à l'opposé des doigts interdigités, par une piste électrique 17, 27, 37, 47 relativement large, (une trentaine de microns de large, et une centaine de microns de long, ou plus) destinée au raccordement électrique des électrodes. Dans ce mode de réalisation, les connections électriques entre électrodes sont réalisées par « pontage », c'est-à-dire en soudant un fil électrique pour connecter les deux électrodes à relier électriquement ensemble (connexion appelée « wire bonding », en anglais). Ainsi, les premières électrodes 10, par exemple, sont reliées les unes aux autres par ces fils soudés (et il en est de mêmes des électrodes 20, ou des électrodes 30 ou 40).

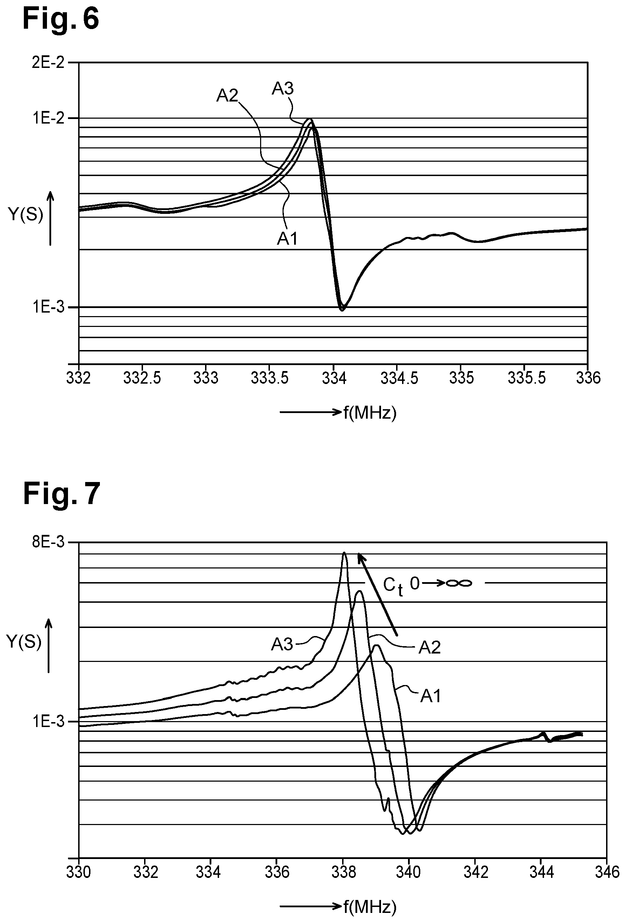

La figure 6 montre trois courbes de résonance A1, A2 et A3 obtenues en mesurant l'admittance Y présentée par le dispositif électromécanique 5 entre sa première borne de connexion (reliée aux premières électrodes 10) et sa deuxième borne de connexion (reliée aux deuxièmes électrodes 20). La courbe A3 est obtenue en court-circuit les premières électrodes 30 avec les deuxième électrodes 40, pour les transducteurs de pilotage T_{T} (ce qui est équivalent, d'un point de vue électrique, à connecter un condensateur de capacité extrêmement grande entre ces électrodes). La courbe A2 est obtenue en connectant une capacité de 0,3 picofarad entre les premières électrodes 30 et les deuxièmes électrodes 40. Et la courbe A1 est obtenue en circuit ouvert, c'est-à-dire sans connecter de composant électrique entre les premières électrodes 30 et les deuxièmes électrodes 40 (ce qui est équivalent, d'un point de vue électrique, à un condensateur de capacité extrêmement faible connecté entre ces électrodes).

Comme on peut le voir sur la figure 6, le dispositif électromécanique 5 présente une résonance électrique nette, sans résonances parasites. Sa fréquence de résonance peut effectivement être modifiée en faisant varier la capacité d'un condensateur branché aux bornes des transducteurs de pilotage de fréquence, T_{T}. Mais l'excursion en fréquence obtenue est faible, d'une centaine de kHz environ. De plus, l'écart entre résonance et antirésonance est plus faible que ce qui pourrait être attendu au vu de simulations numériques (figure 3, par exemple).

Cette accordabilité limitée est attribuée à des effets indésirables liés à la connexion par liaison filaire (par « pontage »), notamment l'introduction de capacités ou inductances parasites de valeurs fixes.

Aussi, dans les autres modes de réalisation, les connexions électriques entre les électrodes du dispositif électromécanique 8 ; 9 ; 12 ; 14 ; 16 sont réalisées au moyen de pistes électriques réalisées sur la surface S du support 100, ou sur l'une des surfaces S1, S2 du support 200, comme représenté sur la figure 8, par exemple. En pratique, cela permet effectivement d'obtenir une plage d'accordabilité plus étendue qu'avec des connexions par « pontage » (voir les courbes expérimentales de la figure 7, par exemple).

Des dispositions particulières sont alors mises en œuvre pour éviter un chevauchement entre les pistes électriques qui sont réalisées sur une même surface du support (chevauchement qui, à nouveau, serait source de capacités et/ou d'inductances parasites), comme décrit maintenant en référence aux figures 8 et 9.

Les deuxième et troisième modes de réalisation sont représentés respectivement sur les figures 8 et 9.

Dans ces deux modes de réalisation, pour éviter un chevauchement entre pistes électriques :
- les pistes électriques qui connectent les électrodes des transducteurs d'interfaçage T_{I} sont réalisées d'un premier côté, 71, du chemin de propagation C,
- tandis que les pistes électriques qui connectent les électrodes des transducteurs de pilotage T_{T} sont réalisées de l'autre côté du chemin de propagation (d'un deuxième côté, 72, de ce chemin de propagation).

Pour réaliser ces connexions soit d'un côté, soit de l'autre du chemin de propagation C (afin d'éviter un croisement ou chevauchement entre pistes), on a recours à des dispositions particulières : certaines électrodes sont reliées les unes aux autres non pas par leur corps principal (comme c'est le cas pour les électrodes 10, par exemple), mais, de manière originale, par l'extrémité de leurs doigts 21 périphériques (électrodes 20, par exemple), qui ont l'avantage d'être situé du côté adapté du chemin de propagation.

Le premier côté 71 du chemin de propagation désigne la partie de la surface S (ou, plus généralement la zone de l'espace) située d'un côté du chemin de propagation C, par exemple à gauche de celui-ci. Le deuxième côté 72 du chemin de propagation désigne la partie de la surface S (ou, plus généralement la zone de l'espace) située de l'autre côté du chemin de propagation C, par exemple à droite de celui-ci. Comme déjà indiqué, le chemin de propagation C, qui correspond au chemin de propagation *moyen* suivi par les ondes élastiques dans le résonateur, est un segment, qui s'étend du réflecteur R1 au réflecteur R2. Ce segment passe approximativement au milieu de chaque doigt des électrodes interdigitées (il coïncide avec l'axe du résonateur). Chaque doigt des électrodes interdigitées s'étend d'un côté à l'autre du chemin de propagation C (c'est-à-dire traverse le chemin C).

Pour chaque transducteur d'interfaçage T_{I}, les doigts 11 de la première électrode 10 du transducteur se raccordent les uns aux autres du premier côté, 71, du chemin de propagation C. En d'autres termes, la bande longitudinale commune, conductrice, à laquelle se raccordent ces différents doigts 11 (bande qui est perpendiculaire aux doigts), qui forme le corps de l'électrode 10 en forme de peigne (corps principal de l'électrode, en quelque sorte), est situé du premier côté, 71, du chemin de propagation C.

Les premières électrodes 10 sont connectées les unes aux autres par des premières pistes électriques, 12, situées entièrement du premier côté 71 du chemin de propagation C. Pour chaque couple de premières électrodes 10 voisines (c'est-à-dire qui se suivent immédiatement le long du chemin de propagation, avec un seul transducteur de pilotage T_{T} intercalé entre elles), les corps respectifs des deux électrodes 10 sont reliées l'un à l'autre par l'une des premières pistes 12'. L'ensemble des premières électrodes 10 et des première pistes 12' a une forme globale de peigne (peigne à grande échelle, en quelque sorte), dont chaque dent correspond à l'une des électrodes 10 (elle-même formée de plusieurs doigts 11). Le corps de ce peigne est situé du premier côté 71 du chemin C.

Pour chaque transducteur d'interfaçage Ti, les doigts 21 de la deuxième électrode 20 du transducteur se raccordent les uns aux autres du deuxième côté, 72, du chemin de propagation C (à l'opposé des premières pistes 12') : le corps de cette électrode en forme de peigne est situé du deuxième côté du chemin C. Cette deuxième électrode 20 comprend un doigt de plus que la première électrode 10 à laquelle elle est associée (c'est-à-dire que la première électrode 10 entre les doigts 11 de laquelle s'insèrent les doigts 21 de cette deuxième électrode 20). Les deux doigts 21 périphériques de cette électrode 20 encadrent, sont situés de part et d'autre (en quelque sorte enserrent), l'ensemble des doigts 11 de la première électrode 10. Les deux doigts 21 périphériques de l'électrode 20 considérée sont les deux doigts de cette électrode qui sont les plus éloignés l'un de l'autre (tout en ayant pour plus proche voisin l'un des doigts 11 de la première électrode 10 du transducteur considéré). Ces deux doigts 21 périphériques ont chacun une première extrémité, par laquelle ils se raccordent au corps de l'électrode 20, et une deuxième extrémité opposée, située du premier côté 71 du chemin de propagation C.

Pour chaque couple de deuxièmes électrodes 20 voisines (c'est-à-dire qui se suivent l'une l'autre le long du chemin de propagation), les deux électrodes 20 en question sont reliées l'une à l'autre par une deuxième piste 22. Cette deuxième piste s'étend entièrement du premier côté 71 du chemin de propagation. Elle relie :
- la deuxième extrémité de l'un des doigts 21 périphériques de l'une de ces deux électrodes 20 (en l'occurrence, le doigt périphérique de cette électrode qui est le plus proche de l'autre électrode 20 du couple considéré), à
- la deuxième extrémité de l'un des doigts 21 périphériques de l'autre électrode 20 du couple considéré (en l'occurrence, le doigt périphérique de cette électrode qui est le plus proche de l'autre électrode 20 du couple considéré).

Ainsi, au lieu de raccorder le corps de l'une des deux électrodes 20 au corps de l'autre électrode 20 du couple considéré (comme c'est le cas pour les premières électrodes 10, par exemple), on raccorde ces deux électrodes 20 par leurs doigts 21 périphériques respectifs, plus précisément par la deuxième extrémité de ces doigts 21 périphériques, qui a l'avantage d'être situé du premier côté 71 du chemin de propagation C. Ainsi, même si les corps des deuxièmes électrodes 20 sont situés du deuxième côté du chemin C, on peut raccorder ces électrodes en passant seulement du premier côté 71 de ce chemin, laissant ainsi le deuxième côté 72 du chemin de propagation libre pour la connexion des électrodes des transducteurs de pilotage T_{T}.

L'ensemble comprenant la piste 22 et les deux doigts 21 périphériques qu'elle relie forme une sorte de piste en forme de C, qui, pour contourner le transducteur de pilotage T_{T} situé entre les deux électrodes 20, traverse le chemin C (pour passer du deuxième côté au premier côté du chemin de propagation, se prolonge ensuite parallèlement au chemin C (et du premier côté de ce chemin), puis, après avoir dépassé le transducteur de pilotage T_{T} en question, traverse à nouveau le chemin C pour repasser du deuxième côté 72 afin de se raccorder au corps de l'autre électrode 20.

L'ensemble comprenant les deuxièmes pistes 22, les corps des deuxièmes électrodes 20 et les deux doigts 21 périphériques de chacune de ces électrodes 20 forme une piste principale qui serpente le long du chemin C, en traversant et retraversant plusieurs fois ce chemin pour former des méandres afin de contourner les transducteurs de pilotage T_{T} intercalés entre les transducteurs d'interfaçage T_{I} (voir la figure 8, par exemple).

Les pistes 32, 42 qui connectent les électrodes 30, 40 des transducteurs de pilotage T_{T} sont réalisées de manière comparable aux pistes 12, 22, mais du deuxième côté 72 du chemin de propagation.

Ainsi, pour chaque transducteur de pilotage T_{T}, les doigts 31 de la première électrode 30 du transducteur se raccordent les uns aux autres du deuxième côté 72 du chemin de propagation C. Le corps de l'électrode 30 est ainsi situé du deuxième côté 72 de ce chemin. Pour chaque couple de deuxièmes électrodes 30 voisines, les deux électrodes en question sont reliées l'une à l'autre par une troisième piste 32, située entièrement du deuxième côté 72 du chemin C. L'ensemble des premières électrodes 30 et des troisième pistes 32 a une forme globale de peigne dont chaque dent correspond à l'une des électrodes 30 (peigne à grande échelle, en quelque sorte), le corps de ce peigne étant situé du deuxième côté 72 du chemin C.

Par ailleurs, pour chaque transducteur de pilotage T_{T}, les doigts 41 de la deuxième électrode 40 du transducteur se raccordent les uns aux autres du premier côté 71 du chemin de propagation C, le corps de cette électrode étant ainsi situé du premier côté du chemin C. Cette deuxième électrode 40 comprend un doigt de plus que la première électrode 30 à laquelle elle est associée. Les deux doigts 41 périphériques de cette électrode 40 encadrent l'ensemble des doigts 31 de la première électrode 30. Ces deux doigts 41 périphériques ont chacun une première extrémité, par laquelle ils se raccordent au corps de l'électrode 40, et une deuxième extrémité opposée, située du deuxième côté 72 du chemin de propagation C.

Pour chaque couple de deuxièmes électrodes 40 voisines (c'est-à-dire qui se suivent l'une l'autre, le long du chemin de propagation), les deux électrodes 40 en question sont reliées l'une à l'autre par une quatrième piste 42. Cette quatrième piste s'étend entièrement du deuxième côté 72 du chemin de propagation. Elle relie :
- la deuxième extrémité de l'un des doigts 41 périphériques de l'une de ces deux électrodes 40 (en l'occurrence, le doigt périphérique de cette électrode qui est le plus proche de l'autre électrode 40 du couple considéré), à
- la deuxième extrémité de l'un des doigts 41 périphériques de l'autre électrode 40 du couple considéré (en l'occurrence, le doigt périphérique de cette électrode qui est le plus proche de l'autre électrode 40 du couple considéré).

Là aussi, l'ensemble comprenant les quatrièmes pistes 42, les corps des deuxièmes électrodes 40 et les deux doigts 41 périphériques de chacune de ces électrodes 40 forme une piste principale qui serpente le long du chemin C, en traversant et retraversant plusieurs fois ce chemin pour former des méandres afin de contourner les transducteurs d'interfaçage T_{I} intercalés entre les transducteurs de pilotage T_{T}.

Dans le mode de réalisation de la figure 8 (et contrairement au mode de réalisation de la figure 9), les deuxièmes électrodes 20 des transducteurs d'interfaçage T₁ restent isolés électriquement des deuxièmes électrodes 40 des transducteurs de pilotage T_{T}.

Tel que représenté, le résonateur 80 du dispositif 8 comprend cinq transducteurs d'interfaçage T_{I} et cinq transducteurs de pilotage de fréquence T_{T}. Pour chaque transducteur d'interfaçage T_{I}, la première électrode 10 du transducteur comprend quatre doigts, 11, tandis que la deuxième électrodes 20 comprend cinq doigts, 21. De même, pour chaque transducteur de pilotage T_{T}, la première électrode 30 du transducteur comprend quatre doigts 31, tandis que la deuxième électrodes 40 comprend cinq doigts, 41. L'ensemble de transducteurs comprend ainsi 90 doigts, répartis régulièrement (périodiquement) le long du chemin de propagation C des ondes élastiques.

La figure 7 montre trois courbes de résonance A1, A2 et A3 obtenues en mesurant l'admittance Y (exprimée en Siemens) présentée par le dispositif électromécanique 8 entre sa première borne de connexion 75 et sa deuxième borne de connexion 76, en fonction, de la fréquence f (exprimée en mégaHertz). La courbe A3 est obtenue en court-circuitant les premières électrodes 30 avec les deuxième électrodes 40, pour les transducteurs de pilotage T_{T} (Z=0). La courbe A1 est obtenue au contraire en circuit ouvert (Z infinie), et la courbe A2 est obtenue en connectant une capacité intermédiaire, de 1 picofarad, entre les premières électrodes 30 et les deuxièmes électrodes 40.

Comme on peut le voir sur la figure 7, le dispositif électromécanique 8 présente une résonance électrique nette, sans résonances parasites, avec une plage d'accordabilité (d'environ 1 MHz) nettement plus étendue que pour le dispositif 5, et avec une résonance mieux séparée de l'antirésonance (environ 1,8 MHz d'écart), ce qui montre l'intérêt du mode de connexion particulier employé dans ce cas (connexion par pistes, et sans chevauchement).

Dans le dispositif électromécanique 8 de la figure 8, chaque deuxième électrode 20 est reliée à l'une des deuxièmes pistes 22 par l'un de ses doigts 21 périphériques. En variante, on pourrait prévoir que chaque deuxième électrode 20 soit reliée à l'une des deuxièmes pistes 22 non seulement par l'un de ses doigts 21 périphériques, mais aussi par un ou plusieurs doigts supplémentaires s'étendant transversalement par rapport au chemin de propagation, en traversant le chemin de propagation C et situé entre le transducteur d'interfaçage T_{I} considéré et le transducteur de pilotage T_{T} adjacent (comme dans le cas de la figure 9). De même, chaque deuxième électrode 40 pourrait être reliée à l'une des quatrièmes pistes 42, non seulement par l'un de ses doigts 41 périphériques mais aussi par un ou plusieurs tels doigts supplémentaires. Relier ainsi la deuxième électrode 20 à la deuxième piste 22 (ou l'une des deuxièmes électrodes 40 et l'une des quatrièmes pistes 42) par plusieurs doigts au lieu d'un seul permet de réduire la résistance électrique, et l'inductance entre deux deuxièmes électrodes 20 successives. En d'autres termes, cela permet de mieux transférer le potentiel électrique commun de l'une des deuxièmes électrodes 20 (ou 40) à la suivante. Toutefois, lorsque plusieurs tels doigts « de transfert de potentiel électrique » sont intercalés entre un transducteur d'interfaçage T_{I} et un transducteur de pilotage T_{T} voisin, cela revient, d'un point acoustique, à intercaler un réflecteur partiel entre ces deux transducteurs T_{I} et T_{T}. Cela contribue alors à isoler deux sections adjacentes du résonateur, et peut par conséquent entrainer une réduction du coefficient de couplage électromécanique du dispositif, et une augmentation de la contribution de la résonance propre des sections de transducteurs (modes localisés sur une partie seulement du résonateur).

Il est donc souhaitable de trouver un compromis entre une réduction de la résistance et inductance de mise en contact électrique (qui incite à augmenter le nombre de doigts de transfert de potentiel électrique) d'une part, et une réduction du coefficient de réflexion entre transducteurs successifs d'autre part (ce qui incite à limiter le nombre de doigts de transfert de potentiel électrique). Des résultats de simulation numérique montrent qu'il est préférable que le nombre total de doigts de transfert de potentiel électrique (y compris les doigts 21, 41 périphériques des deuxièmes électrodes elles-mêmes) soit compris entre 1 et 10, voire entre 1 et 4.

Le mode de réalisation de la figure 9 est comparable au mode de réalisation de la figure 8, mais les deuxièmes électrodes 20 des transducteurs d'interfaçage T_{I} et les deuxièmes électrodes 40 des transducteurs de pilotage T_{T} sont reliées électriquement entre elles (court-circuitées) pour former une masse électrique commune.

Par ailleurs, dans ce mode de réalisation chacune des deuxièmes pistes 22 forme, avec la deuxième électrode 40 de l'un des transducteurs de pilotage T_{T}, une même bande longitudinale conductrice, située du premier côté 71 du chemin de propagation C. En d'autres termes, cette deuxième piste 22 et cette deuxième électrode 40 sont confondues l'une avec l'autre (voir la figure 9).

De même, chacune des quatrièmes pistes 42 forme, avec la deuxième électrode 20 de l'un des transducteurs d'interfaçage T_{I}, une même bande longitudinale conductrice, située cette fois-ci du deuxième côté 72 du chemin de propagation.

Pour chaque couple comprenant l'un des transducteurs d'interfaçage T_{I}, et l'un des transducteurs de pilotage T_{T} adjacent de ce transducteur d'interfaçage (voisin le plus proche de ce transducteur d'interfaçage) : la deuxième électrode 20 du transducteur d'interfaçage T_{I} est en contact électrique avec la deuxième électrode 40 du transducteur de pilotage T_{T} par l'intermédiaire de leurs doigts périphériques respectifs, 21 et 41, et aussi, ici, par l'intermédiaire de doigts supplémentaires 26, intercalés entre ces deux transducteurs, T_{I} et T_{T} (plus précisément, intercalés entre les doigts périphériques en question, 21 et 41). Chacun de ces doigts supplémentaires 26 s'étend transversalement par rapport au chemin de propagation C, en le traversant pour relier la deuxième électrode 20 à la deuxième électrode 40.

Dans l'exemple de la figure 9, pour chaque couple comprenant l'un des transducteurs d'interfaçage T_{I}, et l'un des transducteurs de pilotage T_{T} adjacent de ce transducteur d'interfaçage, l'ensemble des doigts de transfert de potentiel électrique, situés entre ces deux transducteurs, c'est-à-dire les deux doigts périphériques 21 et 41, et les doigts supplémentaires 26, comprend dix doigts en tout (soit huit doigts supplémentaires 26). Un nombre de doigts de transfert de potentiel électrique différent, par exemple plus petit, pourrait toutefois être choisi, en variante.

Dans le résonateur 90 de la figure 9, les corps principaux des deuxièmes électrodes 20 et 40, leurs doigts périphériques, 21 et 41, et les doigts supplémentaires 26 mentionnés plus haut forment ensemble une même piste principale 60 qui serpente le long du chemin de propagation C, de part et d'autre de ce chemin (en traversant et retraversant plusieurs fois le chemin de propagation), en formant des méandres permettant de contourner les premières électrodes 10 et 30 des transducteurs de pilotage T_{T} et des transducteurs d'interfaçage T_{I}.

La figure 10 montre trois courbes de résonance A1, A2 et A3 obtenues en mesurant l'admittance Y (exprimée en Siemens) présentée par le dispositif électromécanique 9 entre sa première borne de connexion (reliée aux premières électrodes 10) et sa deuxième borne de connexion (reliée aux deuxièmes électrodes 20), en fonction de la fréquence f (exprimée en mégaHertz). La courbe A3 est obtenue en court-circuit les premières électrodes 30 avec les deuxième électrodes 40, pour les transducteurs de pilotage T_{T} (Z=0). La courbe A1 est obtenue au contraire en circuit ouvert (Z infinie), et la courbe A2 est obtenue en connectant une capacité intermédiaire, de 3 picofarad entre les premières électrodes 30 et les deuxièmes électrodes 40.

Comme on peut le voir sur la figure 10, le dispositif électromécanique 9 présente une résonance électrique nette, avec une plage d'accordabilité satisfaisante. Cette plage d'accordabilité est toutefois légèrement moins grande que dans le cas du dispositif 8 de la figure 8, et la résonance est moins séparée de l'antirésonance. Les résonances parasites (correspondant à des modes localisés) sont également un peu plus marquées que pour le dispositif 8 de la figure 8. Ces observations peuvent s'expliquer par le fait que le nombre de doigts de transfert de potentiel électrique est plus important pour cet exemple (ce nombre étant en l'occurrence égal à 10) que pour le résonateur 80, augmentant ainsi l'importance des réflexion partielles à l'interface entre deux transducteurs successifs.

Différentes variantes peuvent être apportées aux dispositifs électromécaniques 5 ; 8 ; 9 à ondes de surface qui viennent d'être présentés, pour améliorer encore leur performances (agilité en fréquence notamment).

On pourrait par exemple choisir des orientations cristallines différentes, pour le substrat de niobate de lithium (ou choisir un autre type de substrat), afin d'obtenir un coefficient de couplage électromécanique plus grand. Ainsi, plutôt qu'utiliser la coupe X, on pourrait utiliser des orientations Y+64° ou Y+128°.

On pourrait utiliser des réflecteurs comprenant un nombre de doigts (nombre de périodes) différents, par exemple un nombre de doigts plus grand, pour améliorer leur coefficient de réflexion, et donc le facteur de qualité des résonateurs.

Une diminution des dimensions d'ensemble du résonateur (en particulier une diminution du pas entre doigts successifs) permettrait d'augmenter la fréquence de fonctionnement (fréquence de résonance plus élevée).

Par ailleurs, au lieu d'employer un substrat monocristallin comme support, on pourrait avoir recours à une structure multicouche, ce qui autorise l'exploitation d'ondes mieux confinées près de la surface, plus rapides, et possédant une dérive moindre de leurs caractéristiques de propagation avec la température.

### Résonateurs à ondes de plaque

Les quatrième, cinquième et sixième modes de réalisation du dispositif électromécanique, 12 ; 14 et 16, pour lesquels le résonateur est un résonateur à ondes de plaque, sont présentés maintenant, en référence aux figures 12, 14 et 16 respectivement.

Comme déjà indiqué, pour ces trois modes de réalisation, le support 200 est une plaque mince, d'épaisseur généralement inférieure à 6 longueurs d'ondes (ou 12 fois la période des électrodes).

Ici, il s'agit d'une plaque en niobate de lithium en coupe X, dont l'épaisseur es est de 0,39 microns. Les réflecteurs R1 et R2 sont disposés de manière à ce que l'axe de propagation des ondes élastiques dans le résonateur, axe qui relie ces deux réflecteurs, fasse, dans le plan de coupe, un angle de 170 degrés avec l'axe cristallographique Y.

Les électrodes des transducteurs, les réflecteurs et les pistes électriques de connexion sont réalisées dans un matériau conducteur, par exemple un matériau métallique. Ici, elles sont réalisées en aluminium. Leur épaisseur (extension perpendiculairement à la surface S) est comprise typiquement entre 0,01 et 1 micron ; Ici, par exemple, elle est de 235 nanomètres. Les transducteurs et les réflecteurs sont réalisés avec un rapport de métallisation compris par exemple entre 10 et 60 % (ici, de 30% environ). Les différents doigts 11, 21, 31, 41, des électrodes des transducteurs et des réflecteurs R1, R2 sont séparés deux à deux par une période spatiale de 2,3 microns, ici, et ont chacun une largeur (extension propre, parallèlement au chemin de propagation C), de 0,7 microns. Un rapport de métallisation légèrement plus faible que pour les résonateurs à ondes de surface est employé, pour réduire le coefficient de réflexion de l'onde au niveau de chaque électrode, et ainsi éviter la localisation des ondes dans une seule région du résonateur.

En effet, comme l'épaisseur des électrodes est comparable à celle de la plaque 200, une onde de plaque subit une réflexion assez forte lors de son passage sous chaque doigt d'électrode (le coefficient de réflexion correspondant peut par exemple atteindre 30 %). Dans ces conditions, les couplages élastiques entre jeux de doigts successifs deviennent rapidement faibles, le long du chemin de propagation C. Il est donc souhaitable, pour ces résonateurs à ondes de plaque 120 ; 140, de quasiment alterner successivement un doigt 11, 21 permettant l'interfaçage électrique du résonateur, et un doigt 31, 41 permettant le pilotage en fréquence.

Aussi, pour ce type de résonateur, il est prévu que chacune desdites électrodes, 10, 20, 30, et 40 comprenne au plus trois doigts.

Plus précisément, dans le quatrième et cinquième modes de réalisation (figures 12 et 14 respectivement), chacune des premières électrodes 10 et 30 comprend un seul doigt, et chacune des deuxièmes électrodes 20 et 40 comprend seulement deux doigts, qui viennent enserrer le doigt unique de la première électrode correspondante. Ainsi, chaque transducteur comprend trois doigts en tout, pour ces deux exemples de réalisation.

Pour ces trois dispositifs 12 ; 14 ; 16 à résonateurs à ondes de plaque, les électrodes 10, 20, 30, 40 des transducteurs sont, là encore, reliées électriquement les unes aux autres par des pistes électriques, 12, 22, 32 et 42, réalisées chacune sur l'une ou sur l'autre des deux surfaces S1 et S2 du support 200. Les pistes qui sont réalisées sur la même surface de ce support, S1 ou S2, ne se chevauchent pas.

Dans le quatrième mode de réalisation (figures 11 et 12), les différents éléments du résonateur 120, c'est-à-dire les réflecteurs R1, R2, les transducteurs T_{T}, T_{I} et les pistes de connexion, 12, 22, 32, 42, sont réalisés sur la même surface, S1, du support 200. Pour éviter un chevauchement entre pistes, on a alors recours aux mêmes dispositions que pour les dispositifs 8 et 9, à ondes de surfaces, présentés plus haut.

Pour les transducteurs d'interfaçage T_{I}, les premières électrodes 10 sont reliées les unes aux autres par des premières pistes 12' situées entièrement du premier côté 71 du chemin de propagation C. Et les deuxièmes électrodes 20 sont reliées les unes aux autres par des deuxièmes pistes 22 situées, elles aussi, entièrement du premier côté 71 du chemin de propagation.

Et pour les transducteurs de pilotage T_{T}, les premières électrodes 30 sont reliées les unes aux autres par des troisièmes pistes 32 situées entièrement d'un deuxième côté 72 du chemin de propagation C. Et les deuxièmes électrodes 40 sont reliées les unes aux autres par des quatrièmes pistes 42 situées, elles aussi, entièrement du deuxième côté 72 du chemin de propagation.

Ici, comme les premières électrodes 10 ont chacune un seul doigt, l'ensemble comprenant ces premières électrodes 10, et les premières pistes 12' qui les relient, forme un peigne, dont le corps s'étend parallèlement au chemin C, du premier côté 71 de ce chemin, sur quasiment toute la longueur du chemin de propagation, et dont chaque doigt est formé par l'une des premières électrodes 10, c'est-à-dire par le doigt unique de cette électrode.

L'ensemble comprenant les premières électrodes 30, et les premières pistes 32 qui les relient, forme également un peigne, dont le corps s'étend parallèlement au chemin C, du deuxième côté 72 de ce chemin, sur quasiment toute la longueur de ce chemin de propagation, et dont chaque doigt est formé par l'une des premières électrodes 30 (c'est-à-dire par le doigt unique de cette électrode). Les deux peignes en question sont interdigités : le doigt, constitué par chacune des premières électrodes 10, est intercalé (insérée) entre deux doigts, constituant chacun l'une des premières électrodes 30.

Pour ce qui est des deuxièmes électrodes 20 et 40 et des deuxièmes pistes 22, 42 qui les relient, elles forment ensemble une même piste principale 60 qui serpente le long du chemin de propagation C, de part et d'autre de ce chemin, en contournant alternativement une première électrode 10 à doigt unique (contournement en passant du deuxième côté 72), puis une première électrode 30 à doigt unique (contournement en passant du premier côté 71), et ainsi de suite. Cette piste principale 60 est formée ici d'une bande d'un seul tenant, qui serpente ainsi le long du chemin de propagation C (les doigts 21 et 41 des deuxièmes électrodes 20 et 40 sont confondus deux à deux, et un seul doigt 21/41 sépare une électrode 10 de l'électrode 30 suivante). Cette bande a par exemple une largeur constante.

Sur les figures 11 et 12, une partie seulement des doigts du résonateur 120 sont représentés. En pratique, le résonateur 120, comme d'ailleurs les autres résonateurs 50 ; 80 ; 90 ; 140 décrits ici, comporte un nombre total de doigts (réflecteurs non compris) supérieur ou égal à 40, voire supérieur ou égal à 80, ou même supérieur à 150. Employer un nombre total de doigts élevé permet notamment d'obtenir une impédance relativement proche de 50 Ohms, entre la première et la deuxième borne du dispositif électromécanique (en dehors des fréquences de résonance et d'anti-résonance, bien sûr).

Sur la figure 13, on a représenté l'admittance Y présentée par le dispositif 12 entre ses première et deuxième borne de connexion 75 et 76 (exprimée en Siemens), en fonction de la fréquence f (en GigaHertz). Sept courbes de résonance électriques, obtenues par simulations numériques sont représentées. La courbe A7 est obtenue en court-circuitant les premières électrodes 30 avec les deuxièmes électrodes 40, pour les transducteurs de pilotage T_{T} (Z=0). La courbe A1 est obtenue en connectant une capacité de 1 pF entre ces mêmes électrodes, et la courbe A3 est obtenue en connectant une capacité de 4 pF entre les premières électrodes 30 et les deuxièmes électrodes 40.

Comme on peut le voir sur la figure 13, le dispositif 12 à résonateur à ondes de plaque permet d'obtenir :
- une plage d'accordabilité très large (environ 0,1 GHz, soit 14% de la fréquence de résonance moyenne), dont la largeur est au moins égale à 10 fois la largeur à -3dB du pic de résonance,
- un pic de résonance très fin, et
- une anti-résonance et une résonance particulièrement bien séparées.

Dans les cinquième et sixième modes de réalisation (représentés respectivement sur les figures 15 et 16), certaines électrodes sont réalisées sur la première surface S1 du support du dispositif électromécanique 14 ; 16 (surface supérieure), tandis que les autres électrodes sont réalisées sur la deuxième surface S2 de ce support (surface inférieure). Cela peut compliquer la fabrication du dispositif 14 ; 16 (par rapport au dispositif 12 des figures 11 et 12), mais simplifie en revanche la connexion entre électrodes, puisque cela limite les possibilités de chevauchement.

Dans le cinquième mode de réalisation (figures 14 et 15), les deuxièmes électrodes 20 des transducteurs d'interfaçage T_{I}, et les deuxièmes électrodes 40 des transducteurs de pilotage T_{T} sont en contact électrique et forment ensemble une même masse électrique commune. Ces électrodes 20, 40, et les pistes électriques qui les relient sont réalisées sur la deuxième surface S2 du support 200, comme on peut le voir sur la figure 15. La figure 15 est une vue schématique en coupe d'une partie du dispositif 14, selon un plan de coupe perpendiculaire au support 200 et contenant le chemin de propagation C.

Les premières électrodes 10 des transducteurs d'interfaçage T_{I}, et les premières électrodes 30 des transducteurs de pilotage T_{T} sont réalisées quant à elles sur la première surface S1 du support. On notera que la figure 14 est une vue de dessus du dispositif 14, dans laquelle le support 200 n'est pas visible (il est, en quelque sorte, représenté en transparence). Ainsi, sur cette figure, certaines pistes ou doigts semblent se croiser mais, comme elles sont en fait réalisées sur des surfaces différentes, elles ne se croisent pas, en fait.

L'ensemble comprenant les premières électrodes 10 (à doigt unique) et les premières pistes 12' qui les relient forme un peigne, dont le corps est situé du premier côté 71 du chemin de propagation (comme pour le quatrième mode de réalisation). Et l'ensemble comprenant les premières électrodes 30 (à doigt unique) et les premières pistes 32 qui les relient forme un peigne, dont le corps est situé du deuxième côté 72 du chemin de propagation (ces deux peignes étant interdigités l'un avec l'autre).

La piste de masse, formée par l'ensemble des deuxièmes électrodes 20 et 40, forme également un peigne, avec un corps principal situé du premier ou du deuxième côté (ici du deuxième côté) du chemin de propagation, et des doigts qui (en projection sur la surface S1) s'étendent chacun entre l'une des premières électrodes 10, et la première électrode 30 voisine. Ici, pour chaque couple comprenant l'une des premières électrodes 10, et la première électrode 30 voisine, un seul doigt de cette piste de masse est intercalé entre la première électrode 10 et la première électrode 30 en question.

Dans le sixième mode de réalisation, les transducteurs d'interfaçage T_{I} sont réalisés sur la première surface S1 du support 200, tandis que les transducteurs de pilotage T_{T} sont réalisés sur la deuxième surface S2 du support 200, comme on peut le voir sur la figure 16. La figure 16 est une vue en coupe d'une partie du dispositif 16 selon ce sixième mode de réalisation, le plan de coupe étant perpendiculaire au support (c'est-à-dire perpendiculaire aux surfaces S1 et S2) et contenant le chemin de propagation C. Dans ce sixième mode de réalisation, chaque électrode 10, 20, 30, 40 comprend un unique doigt (et chaque transducteur comprend ainsi deux doigts en tout).

Les transducteurs d'interfaçage forment ensemble deux longs peignes (un pour les premières électrodes, l'autre pour les deuxième électrode), interdigités l'un avec l'autre, et qui s'étendent quasiment tout le long du chemin de propagation. De même, les transducteurs de pilotage dans leur ensemble forment deux longs peignes, interdigités l'un avec l'autre, et qui s'étendent quasiment tout le long du chemin de propagation.

Comme déjà indiqué, chaque transducteur de pilotage T_{T} est intercalé entre deux transducteurs d'interfaçage T_{I}, sauf pour le ou les transducteurs de pilotage T_{T} situés aux extrémités du chemin de propagation. Ainsi, en projection sur l'une des deux surfaces S1, S2, le transducteur de pilotage T_{T} en question est situé (en quelque sorte inséré) entre les deux transducteurs d'interfaçage T_{I} (figure 16).

Différentes variantes peuvent être apportées aux dispositifs électromécaniques 5 ; 8 ; 9 ; 12 ; 14 ; 16 décrits ci-dessus.

En particulier, les transducteurs pourraient comprendre un nombre de doigts différents de ce qui été présenté.

Le nombre de doigts par transducteurs peut être choisi en fonction notamment du coefficient de réflexion attendu pour les ondes élastiques au niveau de chaque doigt et/ou en fonction de l'application visée, plus ou moins tolérante à la présence de résonances parasites correspondant à des modes localisés sur une partie seulement du résonateur.

Lorsque le coefficient de réflexion attendu au niveau de chaque doigt est faible, par exemple parce que les électrodes sont peu épaisses, on peut employer un nombre de doigts par transducteur relativement grand. A titre d'exemple, si ce coefficient est inférieur à 5%, on peut choisir un nombre total de doigts par transducteur supérieur à 10 (ceci étant, un nombre plus petit peut convenir aussi, dans ce cas). En revanche, si le coefficient de réflexion en question est supérieur à 20%, par exemple, on choisira alors de préférence un nombre total de doigts par transducteur inférieur ou égal à trois ou quatre.

Pour ce qui est maintenant de l'application visée, pour un filtre, par exemple, composé de résonateurs dits série, dont la fréquence de résonance est située au milieu de la bande du filtre, et de résonateurs parallèles dont la fréquence d'antirésonance est située au centre de cette même bande, la présence d'une résonance parasite sur les résonateurs série (donc tombant potentiellement dans la bande du filtre) sera plus gênante que sur les résonateurs parallèles. Pour les résonateurs série, on choisira donc de préférence un nombre total de doigts par transducteur réduit (par exemple inférieur ou égal à 10).

## Revendications

1. Dispositif (5 ; 8 ; 9 ; 12 ; 14 ; 16) électromécanique ayant une fréquence de résonance ajustable, comprenant :
- un support (100 ; 200) piézo-électrique délimité par une surface (S), ou par deux surfaces (S1, S2) parallèles entre elles, et
- réalisé sur ce support, un résonateur (50 ; 80 ; 90 ; 120 ; 140) pour des ondes élastiques se propageant parallèlement à ladite ou auxdites surfaces (S ; S1, S2), le résonateur comprenant au moins :
∘ deux réflecteurs (R1, R2) qui délimitent le résonateur et qui sont réfléchissants pour lesdites ondes,
∘ entre les deux réflecteurs, plusieurs transducteurs d'interfaçage (T_{I}) configurés pour générer lesdites ondes à partir d'un signal électrique, et
∘ plusieurs transducteurs de pilotage (T_{T}) de ladite fréquence de résonance,
∘ chacun desdits transducteurs (T_{I}, T_{T}) comprenant une première électrode (10, 30) et une deuxième électrode (20, 40) interdigitées, réalisées chacune sur ladite surface (S), ou sur l'une desdites surfaces (S1, S2) du support (100 ; 200) piézoélectrique, et
- un dispositif électrique (79) de pilotage (T_{T}) de ladite fréquence de résonance, ce dispositif électrique (79) comprenant une première borne (77) et une deuxième borne (78) et présentant entre ces deux bornes une impédance électrique (Z) réglable,
dans lequel :
- pour chaque transducteur de pilotage (T_{T}), la première électrode (30) et la deuxième électrode (40) du transducteur sont connectées respectivement à la première borne et à la deuxième borne (77, 78) dudit dispositif électrique (79) de pilotage, et
- les premières électrodes (10) des différents transducteurs d'interfaçage (T_{I}) sont reliées électriquement les unes aux autres, et les deuxièmes électrodes (20) des transducteurs d'interfaçage (T_{I}) sont également connectées électriquement les unes aux autres, et
- les transducteurs d'interfaçage (T_{I}) et les transducteurs de pilotage (T_{T}) sont disposés le long d'un chemin de propagation (C) suivi par lesdites ondes dans le résonateur avec une alternance entre transducteurs d'interfaçage (T_{I}) et transducteur de pilotages (T_{T}), chaque transducteur de pilotage (T_{T}) étant intercalé entre deux transducteurs d'interfaçage (T_{I}) successifs, ou entre l'un des réflecteurs (R1, R2) et le transducteur d'interfaçage (T_{I}) adjacent.
et dans lequel :
- pour au moins certains des transducteurs d'interfaçage (T_{I}):
∘ les premières électrodes (10) de ces transducteurs d'interfaçage (T_{I}) sont connectées les unes aux autres par une ou plusieurs premières pistes (12') électriques, et
∘ les deuxièmes électrodes (20) de ces transducteurs d'interfaçage (T_{I}) sont connectées les unes aux autres par une ou plusieurs deuxièmes pistes (22) électriques, et
- pour au moins certains desdits transducteurs de pilotage (T_{T}):
∘ les premières électrodes (30) de ces transducteurs de pilotage (T_{T}) sont connectées les unes aux autres par une ou plusieurs troisièmes pistes (32) électriques, et
∘ les deuxièmes électrodes (40) de ces transducteurs de pilotage (T_{T}) sont connectées les unes aux autres par une ou plusieurs quatrièmes pistes (42) électriques,
et dans lequel chacune desdites pistes (12', 22, 32, 42) électriques est réalisées sur la surface (S), ou sur l'une des deux surfaces (S1, S2) du support (100 ; 200) piézoélectrique, et dans lequel les pistes qui sont réalisées sur la même surface (S ; S1, S2) du support piézo-électrique ne se chevauchent pas les unes avec les autres.

2. Dispositif (8 ; 9 ; 12) selon la revendication 1, dans lequel :
- chacune desdites électrodes (10, 20, 30, 40) interdigitées comprend un ou plusieurs doigts (11, 21, 31, 41) et une bande longitudinale conductrice, à partir de laquelle s'étendent le ou lesdits doigts et qui forme le corps principal de l'électrode,
- pour les transducteurs d'interfaçage (T_{I}) :
∘ chacune desdites deuxièmes électrodes (20) comprend au moins un doigt (21) de plus que la première électrode (10) à laquelle elle est associée, deux doigts (21) périphériques de cette deuxième électrode (20) encadrant l'ensemble des doigts (11) de la première électrode (10), ces deux doigts (21) périphériques ayant chacun, à l'opposé du corps principal de la deuxième électrode (20), une extrémité située d'un premier côté (71) dudit chemin de propagation, et dans lequel,
∘ chacune desdites deuxièmes pistes (22) relie l'extrémité de l'un des doigts (21) périphériques d'une desdites deuxièmes électrodes (20) à l'extrémité de l'un des doigts (21) périphériques de la deuxième électrode (20) suivante, les corps principaux desdites deuxièmes électrodes (20) et leurs doigts (21) périphériques formant, avec les deuxièmes pistes (22), une piste globale qui serpente le long du chemin de propagation (C), de part et d'autre dudit chemin, en contournant les transducteurs de pilotage (T_{T}).

3. Dispositif (9) selon la revendication 2, dans lequel, pour chaque transducteur d'interfaçage (T_{I}), le corps principal de la deuxième électrode (20) du transducteur est relié à l'une desdites deuxièmes pistes (22), non seulement par l'un des doigts (21) périphériques de cette deuxième électrode (20) mais aussi par un ou plusieurs doigts supplémentaires (26) qui s'étendent transversalement par rapport au chemin de propagation (C), en traversant le chemin de propagation (C) et qui sont situés entre le transducteur d'interfaçage (T_{I}) considéré et l'un des transducteurs de pilotage (T_{T}), adjacent.

4. Dispositif (9 ; 12) selon l'une des revendications 2 ou 3, dans lequel :
- chacune desdites deuxièmes pistes (22) forme, avec le corps principal de la deuxième électrode (40) de l'un des transducteur de pilotage (T_{T}), une même bande longitudinale conductrice située du premier côté (71) du chemin de propagation (C),
- chacune desdites quatrièmes pistes (42) forme, avec le corps principal de la deuxième électrode (20) de l'un des transducteur d'interfaçage (T_{I}) une même bande longitudinale conductrice située du deuxième côté (72) du chemin de propagation (C),
- les deuxièmes électrodes (20) des transducteurs d'interfaçage (T_{I}) sont en contact électrique avec les deuxièmes électrodes (40) des transducteurs de pilotage (T_{T}), au moins par l'intermédiaire de leurs doigts (21, 41) périphériques, les corps principaux des deuxièmes électrodes (20, 40) et leurs doigts (21, 41) périphériques formant ensemble une même piste principale (60) qui serpente le long du chemin de propagation (C), de part et d'autre dudit chemin, en contournant les premières électrodes (10, 30) des transducteurs de pilotage (T_{T}) et des transducteurs d'interfaçage (T_{I}).

5. Dispositif (8 ; 9 ; 12) selon l'une des revendications 2 à 4, dans lequel :
- les premières et deuxièmes pistes (12, 22) électriques sont situées du premier côté (71) du chemin de propagation (C) des ondes élastiques, tandis que
- les troisièmes et quatrièmes pistes (32, 42) électriques sont situés d'un deuxième côté (72), opposé, du chemin de propagation (C) des ondes élastiques.

6. Dispositif (8 ; 9 ; 12) selon l'une des revendications 2 à 5,
- le corps principal de chacune desdites premières électrodes (10) est situé du premier côté (71) du chemin de propagation (C), et le corps principal de chacune desdites deuxièmes électrodes (20) est situé du deuxième côté (72) du chemin de propagation (C), et
- chacune desdites premières pistes (12) relie le corps principal de l'une des premières électrodes (10) au corps principal de la première électrode (10) suivante.

7. Dispositif (12 ; 14 ; 16) selon l'une des revendications précédentes, dans lequel ledit support (200) forme une plaque mince, délimitée par lesdites deux surfaces (S1, S2), parallèles entre elles.

8. Dispositif (5 ; 8 ; 9 ; 12) selon l'une des revendications précédentes, dans lequel les transducteurs d'interfaçage (T_{I}) et les transducteurs de pilotage (T_{T}) sont réalisés sur la même surface (S ; S1) dudit support (100 ; 200).

9. Dispositif (16) selon la revendication 7, dans lequel les transducteurs d'interfaçage (T_{I}) sont réalisés sur l'une des surfaces (S1) de la plaque (200) tandis que les transducteurs de pilotage (T_{T}) sont réalisés sur l'autre surface (S2) de la plaque (200).

10. Dispositif (14) selon la revendication 7, dans lequel les deuxièmes électrodes (20) des transducteurs d'interfaçage (T_{I}) sont en contact électrique avec les deuxièmes électrodes (40) des transducteurs de pilotage (T_{T}), et dans lequel :
- soit les premières électrodes des transducteurs d'interfaçage,
- soit les premières électrodes des transducteurs de pilotage,
- soit les deuxièmes électrodes (20, 40) des transducteurs d'interfaçage (T_{I}) et des transducteurs de pilotage (T_{T})
sont réalisées sur l'une des surfaces (S2) de ladite plaque (200),
les autres électrodes (10, 30) des transducteurs d'interfaçage (T_{I}) et des transducteurs de pilotage (T_{T}) étant réalisées sur l'autre surface (S1) de ladite plaque (200).

11. Dispositif (5 ; 8 ; 9 ; 12 ; 14 ; 16) selon l'une des revendications 1 à 10, dans lequel, les premières et deuxièmes électrodes (10, 20, 30, 40) comprenant chacune un ou plusieurs doigts (11, 21, 31, 41) qui s'étendent transversalement par rapport audit chemin de propagation (C), pour au moins certaines des premières et deuxièmes électrodes, le nombre total de doigts de l'électrode est inférieur ou égal à 10.

12. Dispositif (12 ; 14 ; 16) selon des revendications 1 à 10 dans lequel, les premières et deuxièmes électrodes (10, 20, 30, 40) comprenant chacune un ou plusieurs doigts (11, 21, 31, 41) qui s'étendent transversalement par rapport audit chemin de propagation (C), pour au moins certaines des premières et deuxièmes électrodes, le nombre total de doigts de l'électrode est compris entre 1 et 3.

13. Dispositif (5 ; 8 ; 9 ; 12 ; 14 ; 16) selon l'une des revendications 1 à 12, dans lequel l'ensemble qui regroupe les différentes électrodes (10, 20, 30, 40) des transducteurs de pilotage (T_{T}) et des transducteurs d'interfaçage (T_{I}) comprend un nombre total de doigts (11, 21, 31, 41) d'électrode supérieur ou égal à 40.

## Patentansprüche

1. Elektromechanische Vorrichtung (5; 8; 9; 12; 14; 16) mit einstellbarer Resonanzfrequenz, umfassend:
- einen piezoelektrischen Träger (100; 200), der durch eine Fläche (S) oder durch zwei zueinander parallele Flächen (S1, S2) begrenzt ist, und
- auf diesem Träger einen Resonator (50; 80; 90; 120; 140) für elastische Wellen, die sich parallel zu der oder den Flächen (S; S1, S2) ausbreiten, wobei der Resonator mindestens umfasst:
∘ zwei Reflektoren (R1, R2), die den Resonator begrenzen und für die Wellen reflektierend sind,
∘ zwischen den beiden Reflektoren mehrere Schnittstellenwandler (T_{I}), die so gestaltet sind, dass sie die Wellen aus einem elektrischen Signal erzeugen, und
∘ mehrere Ansteuerungswandler (T_{T}) für die Resonanzfrequenz,
∘ wobei jeder der Wandler (T_{I}, T_{T}) eine erste Elektrode (10, 30) und eine zweite Elektrode (20, 40) umfasst, die ineinandergreifen und jeweils auf der Oberfläche (S) oder auf einer der Oberflächen (S1, S2) des piezoelektrischen Trägers (100; 200) ausgebildet sind, und
- eine elektrische Vorrichtung (79) zur Steuerung (T_{T}) der Resonanzfrequenz, wobei diese elektrische Vorrichtung (79) einen ersten Anschluss (77) und einen zweiten Anschluss (78) umfasst und zwischen diesen beiden Anschlüssen eine einstellbare elektrische Impedanz (Z) aufweist,
wobei:
- für jeden Ansteuerungswandler (T_{T}) die erste Elektrode (30) und die zweite Elektrode (40) des Wandlers jeweils mit dem ersten Anschluss und dem zweiten Anschluss (77, 78) der elektrischen Ansteuerungsvorrichtung (79) verbunden sind, und
- die ersten Elektroden (10) der verschiedenen Schnittstellenwandler (T_{I}) elektrisch miteinander verbunden sind und die zweiten Elektroden (20) der Schnittstellenwandler (T_{I}) ebenfalls elektrisch miteinander verbunden sind, und
- die Schnittstellenwandler (T_{I}) und die Ansteuerungswandler (T_{T}) entlang eines Ausbreitungswegs (C) angeordnet sind, dem die Wellen im Resonator folgen, wobei sich Schnittstellenwandler (T_{I}) und Ansteuerungswandler (T_{T}) abwechseln und jeder Ansteuerungswandler (T_{T}) zwischen zwei aufeinanderfolgenden Schnittstellenwandlern (T_{I}) oder zwischen einem der Reflektoren (R1, R2) und dem benachbarten Schnittstellenwandler (T_{I}) angeordnet ist,
und wobei:
- für mindestens einige der Schnittstellenwandler (Ti):
∘ die ersten Elektroden (10) dieser Schnittstellenwandler (T_{I}) über eine oder mehrere erste elektrische Leiterbahnen (12') miteinander verbunden sind, und
∘ die zweiten Elektroden (20) dieser Schnittstellenwandler (T_{I}) über eine oder mehrere zweite elektrische Leiterbahnen (22) miteinander verbunden sind, und
- für mindestens einige der Ansteuerungswandler (T_{T}):
∘ die ersten Elektroden (30) dieser Ansteuerungswandler (T_{T}) über eine oder mehrere dritte elektrische Leiterbahnen (32) miteinander verbunden sind, und
∘ die zweiten Elektroden (40) dieser Ansteuerungswandler (T_{T}) über eine oder mehrere vierte elektrische Leiterbahnen (42) miteinander verbunden sind, und
wobei jede der elektrischen Leiterbahnen (12', 22, 32, 42) auf der Oberfläche (S) oder auf einer der beiden Oberflächen (S1, S2) des piezoelektrischen Trägers (100; 200) ausgebildet ist und die Leiterbahnen, die auf derselben Oberfläche (S; S1, S2) des piezoelektrischen Trägers hergestellt sind, sich gegenseitig nicht überlappen.

2. Vorrichtung (8; 9; 12) nach Anspruch 1, in der:
- jede der interdigitalen Elektroden (10, 20, 30, 40) einen oder mehrere Finger (11, 21, 31, 41) und ein längliches Leitungsband umfasst, von dem aus sich der oder die Finger erstrecken und das den Hauptkörper der Elektrode bildet,
- für die Schnittstellenwandler (T_{I}):
∘ jede der zweiten Elektroden (20) mindestens einen Finger (21) mehr umfasst als die erste Elektrode (10), mit der sie verbunden ist, wobei zwei periphere Finger (21) dieser zweiten Elektrode (20) die Gesamtheit der Finger (11) der ersten Elektrode (10) umrahmen, wobei diese beiden peripheren Finger (21) jeweils gegenüber dem Hauptkörper der zweiten Elektrode (20) ein Ende aufweisen, das auf einer ersten Seite (71) des Ausbreitungswegs liegt, und wobei
∘ jede der zweiten Leiterbahnen (22) das Ende eines der peripheren Finger (21) einer der zweiten Elektroden (20) mit dem Ende eines der peripheren Finger (21) der folgenden zweiten Elektrode (20) verbindet, wobei die Hauptkörper der zweiten Elektroden (20) und ihre peripheren Finger (21) zusammen mit den zweiten Leiterbahnen (22) eine Gesamtleiterbahn bilden, die sich entlang des Ausbreitungswegs (C) auf beiden Seiten des Ausbreitungswegs schlängelt und die Ansteuerungswandler (T_{T}) umgeht.

3. Vorrichtung (9) nach Anspruch 2, bei der für jeden Schnittstellenwandler (Ti) der Hauptkörper der zweiten Elektrode (20) des Wandlers mit einer der zweiten Leiterbahnen (22) nicht nur über einen der peripheren Finger (21) dieser zweiten Elektrode (20), sondern auch über einen oder mehrere zusätzliche Finger (26) verbunden ist, die sich quer zum Ausbreitungsweg (C) erstrecken, den Ausbreitungsweg (C) kreuzen und sich zwischen dem betreffenden Schnittstellenwandler (T_{I}) und einem der benachbarten Ansteuerungswandler (T_{T}) befindet.

4. Vorrichtung (9; 12) nach einem der Ansprüche 2 oder 3, in der:
- jede der zweiten Leiterbahnen (22) mit dem Hauptkörper der zweiten Elektrode (40) eines der Ansteuerungswandler (T_{T}) ein und dasselbe längliche Leitungsband bildet, das sich auf der ersten Seite (71) des Ausbreitungswegs (C) befindet,
- jede der vierten Leiterbahnen (42) mit dem Hauptkörper der zweiten Elektrode (20) eines der Schnittstellenwandler (T_{I}) ein und dasselbe längliche Leitungsband bildet, das sich auf der zweiten Seite (72) des Ausbreitungswegs (C) befindet,
- die zweiten Elektroden (20) der Schnittstellenwandler (T_{I}) zumindest über ihre peripheren Finger (21, 41) in elektrischem Kontakt mit den zweiten Elektroden (40) der Ansteuerungswandler (T_{T}) stehen, wobei die Hauptkörper der zweiten Elektroden (20, 40) und ihre peripheren Finger (21, 41) zusammen eine einzige Hauptbahn (60) bilden, die sich entlang des Ausbreitungswegs (C) auf beiden Seiten des Wegs schlängelt und dabei die ersten Elektroden (10, 30) der Ansteuerungswandler (T_{T}) und der Schnittstellenwandler (T_{I}) umgeht.

5. Vorrichtung (8; 9; 12) nach einem der Ansprüche 2 bis 4, in der:
- sich die ersten und zweiten elektrischen Leiterbahnen (12, 22) auf der ersten Seite (71) des Ausbreitungswegs (C) der elastischen Wellen befinden, während
- die dritten und vierten elektrischen Leiterbahnen (32, 42) auf einer zweiten, gegenüberliegenden Seite (72) des Ausbreitungswegs (C) der elastischen Wellen angeordnet sind.

6. Vorrichtung (8; 9; 12) nach einem der Ansprüche 2 bis 5, in der
- der Hauptkörper jeder der ersten Elektroden (10) auf der ersten Seite (71) des Ausbreitungswegs (C) angeordnet ist und der Hauptkörper jeder der zweiten Elektroden (20) auf der zweiten Seite (72) des Ausbreitungswegs (C) angeordnet ist, und
- jede der ersten Leiterbahnen (12) den Hauptkörper einer der ersten Elektroden (10) mit dem Hauptkörper der nächsten ersten Elektrode (10) verbindet.

7. Vorrichtung (12; 14; 16) nach einem der vorstehenden Ansprüche, in der der Träger (200) eine dünne Platte bildet, die durch die beiden zueinander parallelen Flächen (Si, S2) begrenzt ist.

8. Vorrichtung (5; 8; 9; 12) nach einem der vorstehenden Ansprüche, in der die Schnittstellenwandler (T_{I}) und die Ansteuerungswandler (T_{T}) auf derselben Oberfläche (S; S1) des Trägers (100; 200) ausgebildet sind.

9. Vorrichtung (16) nach Anspruch 7, in der die Schnittstellenwandler (T_{I}) auf einer der Oberflächen (S1) der Platte (200) ausgebildet sind, während die Ansteuerungswandler (T_{T}) auf der anderen Oberfläche (S2) der Platte (200) ausgebildet sind.

10. Vorrichtung (14) nach Anspruch 7, in der die zweiten Elektroden (20) der Schnittstellenwandler (T_{I}) in elektrischem Kontakt mit den zweiten Elektroden (40) der Ansteuerungswandler (T_{T}) stehen, und in der:
- entweder die ersten Elektroden der Schnittstellenwandler
- entweder die ersten Elektroden der Ansteuerungswandler,
- oder die zweiten Elektroden (20, 40) der Schnittstellenwandler (T_{I}) und der Ansteuerungswandler (T_{T}) auf einer der Oberflächen (S2) der Platte (200) ausgebildet sind,
wobei die anderen Elektroden (10, 30) der Schnittstellenwandler (T_{I}) und der Ansteuerungswandler (T_{T}) auf der anderen Oberfläche (S1) der Platte (200) ausgebildet sind.

11. Vorrichtung (5; 8; 9; 12; 14; 16) nach einem der Ansprüche 1 bis 10, in der die ersten und zweiten Elektroden (10, 20, 30, 40) jeweils einen oder mehrere Finger (11, 21, 31, 41) umfassen, die sich quer zu dem Ausbreitungsweg (C) erstrecken, wobei für zumindest einige der ersten und zweiten Elektroden die Gesamtzahl der Elektrodenfinger kleiner oder gleich 10 ist.

12. Vorrichtung (12; 14; 16) nach den Ansprüchen 1 bis 10, in der die ersten und zweiten Elektroden (10, 20, 30, 40) jeweils einen oder mehrere Finger (11, 21, 31, 41) aufweisen, die sich quer zu dem Ausbreitungsweg (C) erstrecken, wobei für zumindest einige der ersten und zweiten Elektroden die Gesamtzahl der Elektrodenfinger zwischen 1 und 3 liegt.

13. Vorrichtung (5; 8; 9; 12; 14; 16) nach einem der Ansprüche 1 bis 12, in der die Anordnung, die die verschiedenen Elektroden (10, 20, 30, 40) der Ansteuerungswandler (T_{T}) und der Schnittstellenwandler (T_{I}) zusammenfasst, eine Gesamtzahl von Elektrodenfingern (11, 21, 31, 41) von mindestens 40 umfasst.

## Claims

1. Electromechanical device (5; 8; 9; 12; 14; 16) having an adjustable resonance frequency, comprising:
- a piezoelectric support (100; 200) delimited by a surface (S), or by two surfaces (S1, S2) parallel to each other, and
- made on this support, a resonator (50; 80; 90; 120; 140) for elastic waves propagating parallel to said surface or surfaces (S; S1, S2), the resonator comprising at least:
∘ two reflectors (R1, R2) that delimit the resonator and which are reflective for said waves,
∘ between the two reflectors, several interfacing transducers (T_{I}) configured to generate said waves from an electrical signal, and
∘ several tuning transducers (T_{T}) for controlling said resonance frequency,
∘ each of said transducers (T_{I}, T_{T}) comprising a first electrode (10, 30) and a second electrode (20, 40) that are interdigitated, each made on said surface (S), or on one of said surfaces (S1, S2) of the piezoelectric support (100; 200), and
- an electrical device (79) for controlling said resonance frequency, this electrical device (79) comprising a first terminal (77) and a second terminal (78) and having between these two terminals an adjustable electrical impedance (Z),
in which:
- for each tuning transducer (T_{T}), the first electrode (30) and the second electrode (40) of the transducer are respectively connected to the first terminal and to the second terminal (77, 78) of said electrical control device (79), and
- the first electrodes (10) of the different interfacing transducers (T_{I}) are electrically connected to each other, and the second electrodes (20) of the interfacing transducers (T_{I}) are also electrically connected to each other, and
- the interfacing transducers (T_{I}) and the tuning transducers (T_{T}) are positioned along a propagation path (C) followed by said waves in the resonator with an alternation between interfacing transducers (T_{I}) and tuning transducers (T_{T}), each tuning transducer (T_{T}) being inserted between two successive interfacing transducers (Ti), or between one of the reflectors (R1, R2) and the adjacent interfacing transducer (T_{I}),
and wherein:
- for at least some of the interfacing transducers (T_{I}):
∘ the first electrodes (10) of these interfacing transducers (T_{I}) are connected to each other by one or more first electrical tracks (12'), and
∘ the second electrodes (20) of these interfacing transducers (T_{I}) are connected to each other by one or more second electrical tracks (22), and
- for at least some of said tuning transducers (T_{T}):
∘ the first electrodes (30) of these tuning transducers (T_{T}) are connected to each other by one or more third electrical tracks (32), and
∘ the second electrodes (40) of these tuning transducers (T_{T}) are connected to each other by one or more fourth electrical tracks (42),
and wherein each of said electrical tracks (12', 22, 32, 42) is made on the surface (S), or on one of the two surfaces (S1, S2) of the piezoelectric support (100; 200), and wherein the tracks that are made on the same surface (S; S1, S2) of the piezoelectric support do not overlap with each other.

2. Device (8; 9; 12) according to claim 1 wherein:
- each one of said interdigitated electrodes (10, 20, 30, 40) comprises one or more fingers (11, 21, 31, 41) and a longitudinal conductive strip, from which extend said finger or fingers and which form the main body of the electrode,
- for the interfacing transducers (T_{I}):
∘ each of said second electrodes (20) comprises at least one more finger (21) than the first electrode (10) with which it is associated, two peripheral fingers (21) of this second electrode (20) surrounding the complete set of fingers (11) of the first electrode (10), these two peripheral fingers (21) each having, opposite the main body of the second electrode (20), an end located on a first side (71) of said propagation path (C), and wherein,
∘ each one of said second tracks (22) connects the end of one of the peripheral fingers (21) of one of said second electrodes (20) to the end of one of the peripheral fingers (21) of the next second electrode (20), the main bodies of said second electrodes (20) and their peripheral fingers (21) forming, with the second tracks (22), a global track that meanders along the propagation path (C), on either side of said path, by circumventing the tuning transducers (T_{T}).

3. Device (9) according to claim 2, wherein, for each interfacing transducer (T_{I}), the main body of the second electrode (20) of the transducer is connected to one of said second tracks (22), not only by one of the peripheral fingers (21) of this second electrode (20) but also by one or more additional fingers (26) that extend transversally with respect to the propagation path (C), crossing the propagation path (C) and which are located between the interfacing transducer (T_{I}) considered and the tuning transducer (T_{T}) adjacent to it.

4. Device (9; 12) according to one of claims 2 or 3, wherein:
- each of said second tracks (22) forms, with the second electrode (40) of one of the tuning transducers (T_{T}), a same longitudinal conductive strip located on the first side (71) of the propagation path (C),
- each of said fourth tracks (42) forms, with the second electrode (20) of one of the interfacing transducers (Ti) a same longitudinal conductive strip located on the second side (72) of the propagation path (C),
- the second electrodes (20) of the interfacing transducers (T_{I}) are in electrical contact with the second electrodes (40) of the tuning transducers (T_{T}), at least via their peripheral fingers (21, 41), the main bodies of the second electrodes (20, 40) and their peripheral fingers (21, 41) together forming a same main track (60) that meanders along the propagation path (C), on either side of said path, by circumventing the first electrodes (10, 30) of the tuning transducers (T_{T}) and of the interfacing transducers (T_{I}).

5. Device (8; 9; 12) according to one of claims 2 to 4, wherein:
- the first and second electrical tracks (12, 22) are located on the first side (71) of the propagation path (C) of the elastic waves, while
- the third and fourth electrical tracks (32, 42) are located on a second, opposite side (72) of the propagation path (C) of the elastic waves.

6. Device (8; 9; 12) according to one of claims 2 to 5,
- the main body of each of said first electrodes (10) is located on the first side (71) of the propagation path (C), and the main body of each of said second electrodes (20) is located on the second side (72) of the propagation path (C), and
- each of said first tracks (12) connects the main body of one of the first electrodes (10) to the main body of the next first electrode (10).

7. Device (12; 14; 16) according to one of the preceding claims, wherein said support (200) forms a thin plate, delimited by said two surfaces (S1, S2), parallel to each other.

8. Device (5; 8; 9; 12) according to one of the preceding claims, wherein the interfacing transducers (T_{I}) and the tuning transducers (T_{T}) are made on the same surface (S; S1) of said support (100; 200).

9. Device (16) according to claim 7, wherein the interfacing transducers (T_{I} are made on one of the surfaces (S1) of the plate (200) while the tuning transducers (T_{T}) are made on the other surface (S2) of the plate (200).

10. Device (14) according to claim 7, wherein the second electrodes (20) of the interfacing transducers (T_{I}) are in electrical contact with the second electrodes (40) of the tuning transducers (T_{T}), and wherein:
- either the first electrodes of the interfacing transducers,
- or the first electrodes of the tuning transducers,
- or the second electrodes (20, 40) of the interfacing transducers (T_{I}) and of the tuning transducers (T_{T})
are made on one of the surfaces (S2) of said plate (200),
the other electrodes (10, 30) of the interfacing transducers (T_{I}) and of the tuning transducers (T_{T}) being made on the other surface (S1) of said plate (200).

11. Device (5; 8; 9; 12; 14; 16) according to one of claims 1 to 10 wherein, the first and second electrodes (10, 20, 30, 40) each comprising one or more fingers (11, 21, 31, 41) that extend transversally with respect to said propagation path (C), for at least some of the first and second electrodes, the total number of fingers of the electrode being less than or equal to 10.

12. Device (12; 14; 16) according to any of claims 1 to 10 wherein, the first and second electrodes (10, 20, 30, 40) each comprising one or more fingers (11, 21, 31, 41) that extend transversally with respect to said propagation path (C), for at least some of the first and second electrodes, the total number of fingers of the electrode is comprised between 1 and 3.

13. Device (5; 8; 9; 12; 14; 16) according to one of claims 1 to 12, wherein the assembly that groups together the different electrodes (10, 20, 30, 40) of the tuning transducers (T_{T}) and of the interfacing transducers (Ti) comprises a total number of electrode fingers (11, 21, 31, 41) greater than or equal to 40.
